# EUROPEAN PATENT APPLICATION

(11) **EP 4 451 328 A1**
(43) Date of publication of application: **23.10.2024**
(21) Application number: 23827268.6
(22) Date of filing: 22.06.2023
(51) Int. Cl.: H01L 25/04, H01F 38/14, H01L 21/822, H01L 25/18, H01L 27/04, H04B 5/02

(54) **SEMICONDUCTOR MODULE, SEMICONDUCTOR CHIP, AND METHOD FOR MANUFACTURING SEMICONDUCTOR MODULE**

(30) Priority: 24.06.2022 JP 2022101726; 15.09.2022 JP 2022147441; 21.10.2022 JP 2022168739; 10.04.2023 JP 2023063459
(71) Applicant: Premo, Inc., Tokyo 113-8485 (JP)
(72) Inventor: TSUJI, Hidenori, Tokyo 103-0024 (JP); MIYAMOTO, Junta, Tokyo 103-0024 (JP)
(74) Representative: Hasegawa, Kan
(86) International application number: PCT/JP2023/023164
(87) International publication number: WO 2023/249086

(57) **Abstract**

A semiconductor chip (1a) including a processor (10a), a coil (70a) for performing wireless communication with another semiconductor chip (1b), a positive electrode power supply terminal (62a), and a negative electrode power supply terminal (61a). In a material including a positive electrode power supply area (52) and a negative electrode power supply area (51), the positive electrode power supply area (52) is bonded or abutted against the positive electrode power supply terminal (62a), the negative electrode power supply area (51) is bonded or abutted against the negative electrode power supply terminal (61a), and an area size of at least one of the positive electrode power supply area (52) and the negative electrode power supply area (51) is wider than an area size of an end part of at least one of the positive electrode power supply terminal (62a) and the negative electrode power supply terminal (61a).

## Description

### Field

The present invention relates to a semiconductor module, a semiconductor chip, and a method for manufacturing the semiconductor module.

### Background

Conventionally, in a semiconductor chip module in which a plurality of semiconductor chips are integrated in a single package, wired signal transmission utilizing wire bonding or silicon interposer is used for signal transmission between the integrated semiconductor chips. It is not easy to manufacture such semiconductor chip modules performing wired signal transmission because thousands of communication lines need to be connected between the semiconductor chips and a substrate, and the semiconductor chips need to be bonded at prescribed positions on the substrate with high precision. For such an issue, Patent Literature 1 proposes a technology to reduce the number of communication lines between semiconductor chips and a substrate by utilizing wireless communication using coils instead of wired communication lines.

However, even when signal transmission between the semiconductor chips is performed by wireless communication without using communication lines, it is necessary to connect the substrate and the semiconductor chips with wired power lines to supply power to each of the semiconductor chips in order for the semiconductor chips to function. Therefore, it is necessary to bond the semiconductor chips at prescribed positions on the substrate where power can be supplied. Thus, as in the conventional cases, manufacture thereof is not easy since the semiconductor chips need to be bonded at prescribed positions on the substrate with high precision.

### Citation List

### Patent Literature

[Patent Literature 1] Japanese Patent Application Laid-open No. 2021-87044

### Summary

### Technical Problem

However, in an information processing device described in Patent Literature 1, there is no consideration over a method for mounting power supply lines to the semiconductor chips to enable easier manufacturing.

The present invention is designed in view of the foregoing background, and it is an object thereof to provide a semiconductor module, a semiconductor chip, and a method for manufacturing the semiconductor module that can be manufactured more easily.

### Solution to Problem

A semiconductor chip according to the present invention is a semiconductor chip including a processor, a coil for performing wireless communication with another semiconductor chip, a positive electrode power supply terminal, and a negative electrode power supply terminal, in which, in a material including a positive electrode power supply area and a negative electrode power supply area, the positive electrode power supply area is bonded or abutted against the positive electrode power supply terminal, the negative electrode power supply area is bonded or abutted against the negative electrode power supply terminal, and an area size of at least one of the positive electrode power supply area and the negative electrode power supply area is wider than an area size of an end part of at least one of the positive electrode power supply terminal and the negative electrode power supply terminal.

### Advantageous Effects of Invention

According to the present invention, it is possible to manufacture the semiconductor chip and the semiconductor chip module more easily.

### Brief Description of Drawings

Fig. 1 is a diagram illustrating an example of a hardware configuration of a semiconductor chip according to an embodiment of the present invention.
Fig. 2 is a configuration diagram in which a coil 70 is applied as an example where a sensing unit S30 and a communication unit 40 according to the embodiment of the present invention are mounted.
Fig. 3 is a block diagram illustrating a functional configuration of the semiconductor chip according to the embodiment of the present invention.
Fig. 4 is a block diagram illustrating a functional configuration of a semiconductor chip 103 according to the embodiment of the present invention.
Fig. 5 is a control flowchart for describing a flow of processing according to the embodiment of the present invention.
Fig. 6 includes diagrams illustrating a first implementation example in which the semiconductor chip according to the embodiment of the present invention is mounted on a substrate.
Fig. 7 includes diagrams illustrating a second implementation example in which the semiconductor chip according to the embodiment of the present invention is mounted on a material.
Fig. 8 includes diagrams illustrating a third implementation example in which the semiconductor chip according to the embodiment of the present invention is mounted on a material.
Fig. 9 includes diagrams illustrating a fourth implementation example in which the semiconductor chip according to the embodiment of the present invention is mounted on a material.
Fig. 10 is a diagram illustrating an example of a configuration diagram of the semiconductor chip according to the fourth implementation example.
Fig. 11 is a diagram illustrating another example of a configuration diagram of the semiconductor chip according to the fourth implementation example.
Fig. 12 is a configuration diagram of the semiconductor chip according to the embodiment of the present invention, when supplying a plurality of levels of voltage to the semiconductor chip (fifth implementation example).
Fig. 13 is a diagram illustrating a first implementation example when supplying a plurality of levels of voltage to the semiconductor chip according to the embodiment of the present invention (fifth implementation example).
Fig. 14 is a diagram illustrating a sixth implementation example in which the semiconductor chip according to the embodiment of the present invention is mounted on a substrate.
Fig. 15 is a diagram illustrating a seventh implementation example in which the semiconductor chip according to the embodiment of the present invention is mounted on a substrate.
Fig. 16 includes diagrams illustrating an eighth implementation example in which the semiconductor chip according to the embodiment of the present invention is mounted on a substrate.
Fig. 17 includes diagrams illustrating a ninth implementation example in which the semiconductor chip according to the embodiment of the present invention is mounted on a substrate.
Fig. 18 is a diagram illustrating a tenth implementation example in which the semiconductor chip according to the embodiment of the present invention is mounted on a substrate.
Fig. 19 is a diagram illustrating an eleventh implementation example in which the semiconductor chip according to the embodiment of the present invention is mounted on a substrate.
Fig. 20 is a flowchart illustrating manufacturing steps of a semiconductor chip module according to the embodiment of the present invention.
Fig. 21 includes diagrams illustrating a twelfth implementation example in which the semiconductor chip according to the embodiment of the present invention is mounted on a material.
Fig. 22 includes diagrams illustrating a thirteenth implementation example in which the semiconductor chip according to the embodiment of the present invention is mounted on a material.
Fig. 23 includes diagrams illustrating a fourteenth implementation example in which the semiconductor chip according to the embodiment of the present invention is mounted on a material.
Fig. 24 includes diagrams illustrating a fifteenth implementation example in which the semiconductor chip according to the embodiment of the present invention is mounted on a material.
Fig. 25 includes diagrams illustrating a sixteenth implementation example in which the semiconductor chip according to the embodiment of the present invention is mounted on a material.
Fig. 26 is a diagram for describing a manufacturing method of the semiconductor module by a continuous transfer method according to the embodiment of the present invention (seventeenth implementation example).
Fig. 27 is a diagram illustrating a configuration example of a case where a communication chip 14 is employed.
Fig. 28 is a diagram for describing a semiconductor module including a semiconductor chip 1a illustrated in a first embodiment and a semiconductor chip 1b according to the seventeenth implementation example.
Fig. 29 is a diagram illustrating an example of an overall configuration of an information processing device according to the embodiment of the present invention (eighteenth implementation example).
Fig. 30 is a diagram illustrating an example of a hardware configuration of the information processing device according to the embodiment of the present invention.
Fig. 31 is a block diagram illustrating a functional configuration of the semiconductor chip according to the embodiment of the present invention.
Fig. 32 is a control flowchart illustrating operations of the information processing device according to the embodiment of the present invention.
Fig. 33 is a chart illustrating an example of wireless signals communicated between the semiconductor chips according to the embodiment of the present invention and voltage values of a coil.
Fig. 34 is a table illustrating an example of information stored in a communication history storage unit of the present invention.
Fig. 35 is a table illustrating an example of information stored in a measurement value storage unit of the present invention
Fig. 36 is a table illustrating an example of information stored in a state quantity storage unit of the present invention.
Fig. 37 is a diagram illustrating another example of the hardware configuration of the information processing device according to the embodiment of the present invention.

### Description of Embodiments

### <Overview of Invention>

Contents of embodiments of the present invention will be listed and described. The present invention includes the following configurations, for example.

### [Item 1]

A semiconductor chip including a processor, a coil for performing wireless communication with another semiconductor chip, a positive electrode power supply terminal, and a negative electrode power supply terminal, in which
in a material including a positive electrode power supply area and a negative electrode power supply area, the positive electrode power supply area is bonded or abutted against the positive electrode power supply terminal,
the negative electrode power supply area is bonded or abutted against the negative electrode power supply terminal, and
an area size of at least one of the positive electrode power supply area and the negative electrode power supply area is wider than an area size of an end part of at least one of the positive electrode power supply terminal and the negative electrode power supply terminal.

### [Item 2]

The semiconductor chip according to item 1, in which
the positive electrode power supply terminal and the negative electrode power supply terminal are disposed on a first face on one side of the semiconductor chip, and
a second face of the semiconductor chip on a side opposite to the first face has a positive electrode area and a negative electrode area with open electrodes.

### [Item 3]

The semiconductor chip according to item 1, in which
terminals of the semiconductor chip are configured only with the positive electrode power supply terminal and the negative electrode power supply terminal.

### [Item 4]

The semiconductor chip according to item 1, in which
communication with the other chip is not performed via the positive electrode power supply terminal and the negative electrode power supply terminal but performed by wireless communication via the coil.

### [Item 5]

The semiconductor chip according to item 1, in which
the processor is provided inside the coil.

### [Item 6]

The semiconductor module according to item 1, further including:
a positive electrode conduction part that electrically connects the positive electrode power supply terminal and the positive electrode area, and a negative electrode conduction part that electrically connects the negative electrode power supply terminal and the negative electrode area.

### [Item 7]

The semiconductor module according to item 5, in which
a first face on the material side includes the first positive electrode power supply terminal and the first negative electrode power supply terminal, and a second face on a side opposite to the first face includes a first positive electrode area where a positive electrode is exposed and a first negative electrode area where a negative electrode is exposed.

### [Item 8]

The semiconductor chip according to item 5, in which
a distance between the positive electrode power supply area and the negative electrode power supply area provided in the material is shorter than a distance between the positive electrode power supply terminal and the negative electrode power supply terminal.

### [Item 9]

The semiconductor module according to item 5, in which
the semiconductor chip includes, on a second face on a side opposite to the material, the first positive electrode power supply terminal, the first negative electrode power supply terminal, a first positive electrode area where a positive electrode is exposed, and a first negative electrode area where a negative electrode is exposed.

### [Item 10]

The semiconductor module according to item 5, in which
the material includes: a first material that includes a positive electrode power supply area connected to the positive electrode power supply terminal of the semiconductor chip; and a second material that includes a negative electrode power supply area connected to the negative electrode power supply terminal of the semiconductor chip, and
the first material and the second material are disposed to sandwich a plurality of the semiconductor chips.

### [Item 11]

The semiconductor module according to item 5, in which
the material includes a power supply element configured to store or generate electricity, and supply power via at least one of the positive electrode power supply area and the negative electrode power supply area.

### [Item 12]

The semiconductor module according to item 5, in which
the semiconductor chip includes an external communication unit configured to perform wireless communication with an external device outside the semiconductor module via the coil.

### [Item 13]

The semiconductor module according to item 5, in which
the semiconductor chip includes a power supply element configured to store or generate electricity, and supply power via at least one of the positive electrode power supply terminal and the negative electrode power supply element.

### [Item 14]

A semiconductor module including:
the semiconductor chip of item 1; and
a sensor connected to the semiconductor chip by a wire, in which
the semiconductor chip performs communication with the sensor via the wire.

### [Item 15]

A semiconductor module including:
a first semiconductor chip and a second semiconductor chip as the semiconductor chips of item 1; and
a sensor connected to the first semiconductor chip by a wire, in which
the processor provided to the first semiconductor chip processes a signal received from the sensor, and transmits processed data to a coil of the second semiconductor chip via the coil by inductive coupling, and
the processor provided to the second semiconductor chip performs processing based on the data received from the coil of the second semiconductor chip.

### [Item 16]

The semiconductor module according to item 15, in which
a positive electrode power supply terminal of the first semiconductor chip and the positive electrode power supply terminal of the second semiconductor chip are bonded or abutted against the same positive electrode power supply area, and
a negative electrode power supply terminal of the first semiconductor chip and the negative electrode power supply terminal of the second semiconductor chip are bonded or abutted against the same negative electrode power supply area.

### [Item 17]

The semiconductor module according to item 15, in which
a width of a positive electrode power supply area and a negative electrode power supply area in a direction where a first semiconductor chip and the second semiconductor chip are disposed is twice or more than a width of the semiconductor chip.

### [Item 18]

The semiconductor module according to item 1, including a third semiconductor chip that includes:
a processor;
a coil for performing wireless communication; and
a positive electrode power supply terminal and a negative electrode power supply terminal configured to acquire driving power of the processor from outside the semiconductor chip, in which
a positive electrode power supply terminal of the third semiconductor chip is bonded or abutted against the same positive electrode power supply area, and
a negative electrode power supply terminal of the third semiconductor chip performs wireless communication by inductive coupling between a coil of the third semiconductor chip bonded or abutted against the same negative electrode power supply area and the coil of the second semiconductor chip.

### [Item 19]

A semiconductor chip including a processor and a coil, the semiconductor chip including:
a communication unit configured to perform communication with another semiconductor chip by using the coil;
a measurement unit configured to acquire a measurement value in accordance with a state of the information processing device by using the coil; and
a power reception unit configured to acquire power consumed in the semiconductor chip by using the coil.

### [Item 20]

The semiconductor chip according to item 19, in which
the power reception unit acquires power in a specific frequency band generated in the coil due to an electromagnetic field generated by an external power supply device, and
the communication unit transmits an unmodulated wireless signal to the coil of another semiconductor chip adjacent to the semiconductor chip via a near-field electromagnetic field.

### [Item 21]

The semiconductor chip according to item 19, including:
a calculation logic storage unit configured to store a calculation logic for calculating a state quantity indicating the state; and
a calculation unit configured to calculate the state quantity from the measurement value by the calculation logic.

### [Item 22]

The semiconductor chip according to item 19, in which
the coil transmits power to a coil outside the semiconductor chip.

### [Item 23]

The semiconductor chip according to item 19, including
a positive electrode power supply terminal and a negative electrode power supply terminal configured to acquire driving power of the processor from outside the semiconductor chip.

### [Item 24]

An information processing device including:
the semiconductor chip of item 19; and
a power supply device configured to transmit power in a specific frequency band to the coil via an electromagnetic field, in which
the communication unit transmits an unmodulated wireless signal to the coil of another semiconductor chip adjacent to the semiconductor chip via a near-field electromagnetic field.

### [Item 25]

A semiconductor module including:
the semiconductor chip of item 19; and
a sensor connected to the semiconductor chip by a wire, in which
the semiconductor chip performs communication with the sensor via the wire.

### [Item 26]

A semiconductor module including:
a first semiconductor chip and a second semiconductor chip as the semiconductor chips of item 19; and
a sensor connected to the first semiconductor chip by a wire, in which
the processor provided to the first semiconductor chip processes a signal received from the sensor, and transmits processed data to a coil of the second semiconductor chip via the coil by inductive coupling, and
the processor provided to the second semiconductor chip performs processing based on the data received from the coil of the second semiconductor chip.

### [Item 27]

A material bonded or abutted against a semiconductor chip that includes a processor, a coil for performing wireless communication with another semiconductor chip, a positive electrode power supply terminal, and a negative electrode power supply terminal, the material including a positive electrode power supply area and a negative electrode power supply area, in which
the positive electrode power supply area is bonded or abutted against the positive electrode power supply terminal,
the negative electrode power supply area is bonded or abutted against the negative electrode power supply terminal, and
an area size of at least one of the positive electrode power supply area and the negative electrode power supply area is wider than an area size of an end part of at least one of the positive electrode power supply terminal and the negative electrode power supply terminal.

### <Hardware>

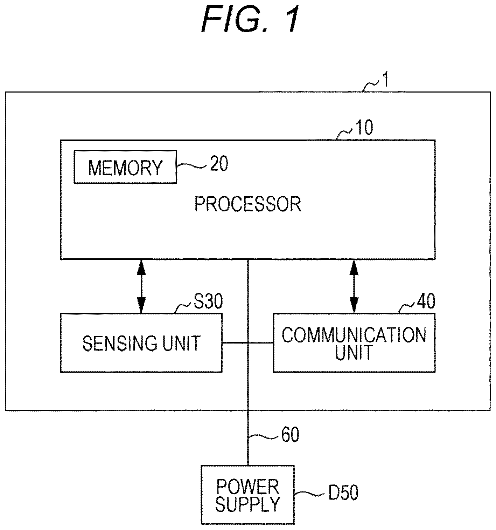

Fig. 1 illustrates an example of a hardware configuration of a semiconductor chip according to an embodiment of the present invention. A semiconductor chip 1 includes a processor 10, a sensing unit S30, and a communication unit 40, and the processor 10 includes a memory 20. The sensing unit S30 measures a measurement value in accordance with the environment where the semiconductor chips are provided. The processor 10 receives and records the measurement value measured by the sensing unit S30 in the memory 20, and calculates an environmental value by giving the measurement value to a calculation logic. The environmental value is a value indicating the state of the environment where the semiconductor chips are provided. The processor 10 records the calculated environmental value in the memory 20. The semiconductor chip 1 further includes a power line D60, and supplies power from an external power supply D50 to the processor 10, the sensing unit S30, and the communication unit 40.

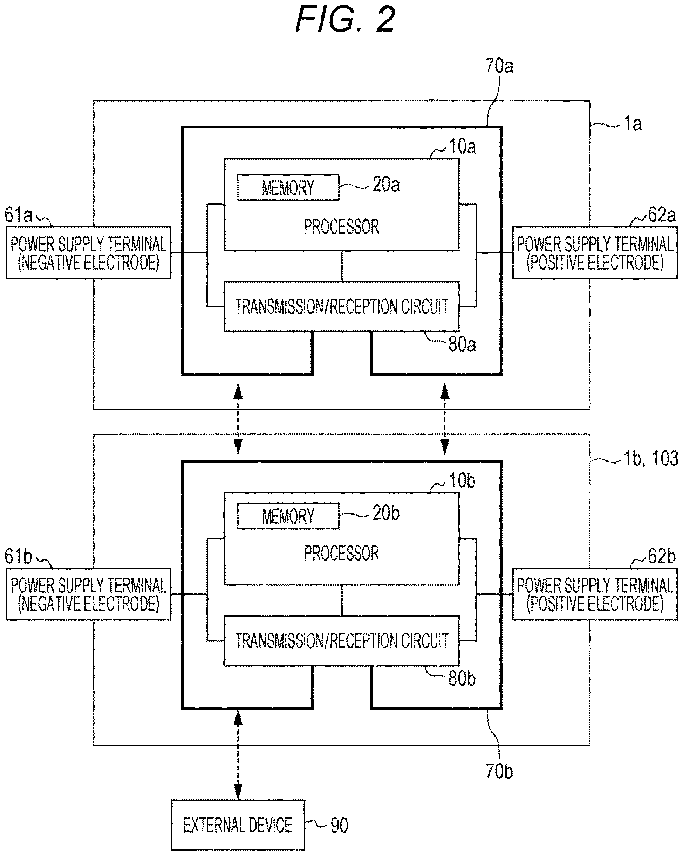

Fig. 2 illustrates an example of a hardware configuration in which a coil 70 is applied as an example where the sensing unit S30 and the communication unit 40 are mounted. The example in Fig. 2 illustrates a case using a pair of semiconductor chips. The semiconductor chips respectively include processors (10a, 10b), memories (20a, 20b) provided in the processors, transmission/reception circuits (80a, 80b) connected to the processors in a communicable manner, coils (70a, 70b) connected to the transmission/reception circuits, first power supply terminals (61a, 61b) on the negative electrode side and second power supply terminals (62a, 62b) on the positive electrode side for supplying power to the processors and the transmission/reception circuits.

Two semiconductor chips (1a, 1b) disposed adjacently in Fig. 2 respectively include the coils (70a, 70b) and the transmission/reception circuits (80a, 80b) that generate signals flowing in the coils, thereby making it possible to transmit and receive signals from each other by inductive coupling with the coil 70 of the other adjacent semiconductor chip.

Furthermore, the semiconductor chip (1b) includes an external communication unit and is capable of transmitting/receiving signals mutually with an external device 90 by wireless communication such as inductive coupling or the like via the coil (70b). As an example, it is possible to receive an environmental value request signal described later and transmit a latest environmental value detected in a semiconductor module and the history of environmental values. Since the semiconductor chip (1b) has a function of communicating with the external device outside the semiconductor module by the external communication unit, it is desirable that the communication range thereof is equal to or wider than that of the semiconductor chip (1a) that communicates with the adjacent semiconductor chip. Therefore, the coil (70b) loaded on the semiconductor chip (1b) may be configured to have more turns than the coil (70a) of the semiconductor chip (1a), and the transmission/reception circuit (80b) loaded on the semiconductor chip (1b) may be configured to output higher voltage or current to the coil than the transmission/reception circuit (80a) of the semiconductor chip (1a).

Furthermore, as the relative distance or relative angle between the coils (70a, 70b) of the two semiconductor chips changes, the coupling strength of the inductive coupling changes, and the voltage value or the amplitude value of the voltage generated in the coils changes. In the present embodiment, through detecting the voltage value or the amplitude value of the voltage generated in the coil by the transmission/reception circuit, the processor 10 can acquire the detected voltage value or amplitude value of the voltage as a measurement value and calculate the environmental change that changes the relative distance and the relative angle between the semiconductor chips as an environmental value. The memory 20 records the calculated environmental value.

The semiconductor chip according to the present embodiment stores calculation logics for each of a plurality of kinds of environmental values, and can calculate those environmental values from the same measurement value. The semiconductor chip can acquire different kinds of environmental values based on the measurement value (voltage measured by the coil 70) of the same sensor by using the calculation logic corresponding to the designated kind. Furthermore, the semiconductor chip according to the present embodiment can be configured with a CPU by mounting the processor, the sensing unit, and the communication unit illustrated in Fig. 1 on a semiconductor chip in an inseparable manner. In such a case, the diameter of the semiconductor chip can be reduced to about 0.3 mm, for example, which allows the semiconductor chip to be made smaller. Note that the size is not limited thereto. For example, the processor, the sensing unit, and the communication unit can be mounted on the semiconductor chip (on a single chip) in an inseparable manner. Note here that a semiconductor chip is defined as a small thin piece of silicon (silicon die or die) on which electronic circuits are assembled. Alternatively, in some cases, it can also be defined as a package in which the silicon die is encapsulated.

### <Software>

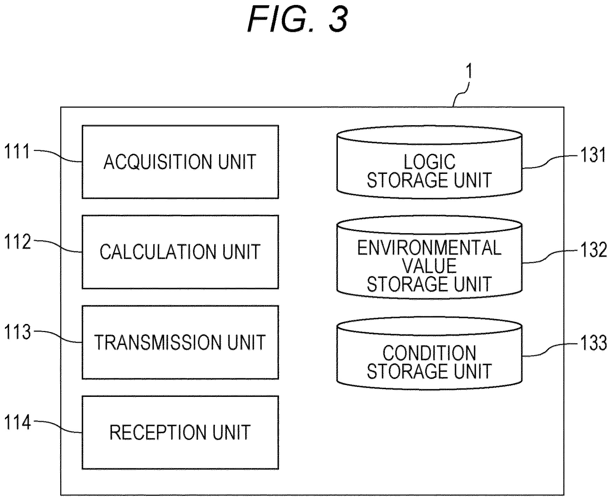

Fig. 3 is a block diagram illustrating a functional configuration of the semiconductor chip. As illustrated in Fig. 3, the semiconductor chip is configured including an acquisition unit 111, a calculation unit 112, a transmission unit 113, a reception unit 114, a logic storage unit 131, an environmental value storage unit 132, and a condition storage unit 133.

The logic storage unit 131 stores the calculation logics. The logic storage unit 131 according to the present embodiment stores the calculation logics for each kind of the environmental value. In the logic storage unit 131, the calculation logics are stored by being linked to the kinds of the environmental values. As described above, the calculation logic includes an algorithm that calculates the environmental value based on the measurement value. The measurement value is the voltage value or the amplitude value of the voltage generated in the coil detected by the transmission/reception circuit, which in the present embodiment can be defined as the voltage value generated in the coil, for example. The environmental values are values related to the environment in which the sensor chip is in and can be, for example, temperature, vibration, pressure, electromagnetic wave, sound volume, and humidity. For example, when the positional relationship between two sensor chips changes, the voltage or amplitude of the voltage generated in the coils changes. It is also known that changes in the relative positional relationship of the two sensor chips may be caused by the temperature, pressure, humidity, and the like around the sensor chips, vibration such as sound or electromagnetic waves given from outside the sensor chips, and vibration and the like of an object in which the sensor chips are embedded, disposed, or affixed. By processing the voltage or change in voltage of the coil caused due to the change in the relative positional relationship of the sensor chips with an appropriate calculation logic, the temperature, vibration, pressure, electromagnetic wave, sound volume, and humidity, for example, can be calculated.

The environmental value storage unit 132 stores the environmental values. The environmental value storage unit 132 according to the present embodiment stores the history of environmental values for each kind. The environmental value storage unit 132 contains, but not limited to, information such as the kinds of environmental values, the environmental values, and the point in time (time stamp) at which the values are calculated. The time stamp may be the point in time at which the measurement value is measured.

The condition storage unit 133 stores information for determining which kind of environmental value is to be calculated. The condition storage unit 133 according to the present embodiment stores, by associating with conditions regarding phenomena that can be acquired by the semiconductor chip, the kinds of environmental values to be calculated when the conditions are satisfied. A plurality of pairs of conditions and kinds of environmental values may be registered. Note that the condition storage unit 133 may store the kinds of environmental values that are calculated unconditionally. Furthermore, the condition storage unit 133 may also store a single or a plurality of kinds of environmental values to be calculated without setting any conditions.

The acquisition unit 111 acquires the measurement value measured by the sensing unit (coil) provided in the semiconductor chip. The acquisition unit 111 according to the present embodiment can acquire the value of the voltage generated in the coil 30 as the measurement value.

The calculation unit 112 calculates the environmental value. The calculation unit 112 can calculate the environmental value from the measurement value using the calculation logic corresponding to the set kind. The calculation unit 112 can calculate the environmental value by, for example, specifying the kind corresponding to the condition that is satisfied among the conditions stored in the condition storage unit 133, reading out the calculation logic corresponding to the specified kind from the logic storage unit 131, and giving the measurement value acquired by the acquisition unit 111 to the read-out calculation logic.

The calculation unit 112 can also calculate a first kind of environmental value using a first calculation logic from the measurement value acquired from the coil 30, and calculate a second kind of environmental value using a second calculation logic different from the first calculation logic. For example, the calculation unit 112 can also give the measurement value to the calculation logic corresponding to temperature as well as to the calculation logic corresponding to humidity to calculate the temperature and the humidity.

Furthermore, the calculation unit 112 can calculate the corresponding environmental value according to the measurement logic that matches the condition. When it is determined, for example, whether time information that can be acquired from a clock (not illustrated), the measurement value acquired from the coil 70, or the like satisfies the conditions stored in the condition storage unit 133 and, when there is a condition that is satisfied, the calculation unit 112 can specify the kind corresponding to the satisfied condition, read out the calculation logic corresponding to the specified kind from the logic storage unit 131, and calculate the environmental value by using the read-out calculation logic.

The reception unit 114 receives signals from outside the semiconductor chip. For example, it is possible to receive, from the adjacent semiconductor chip (1b), identification information of the semiconductor chip (1b), information of the environmental values measured in the semiconductor chip (1b), and the like. Furthermore, it is also possible to receive an environmental value request signal for requesting to output the environmental value stored in the environmental value storage unit.

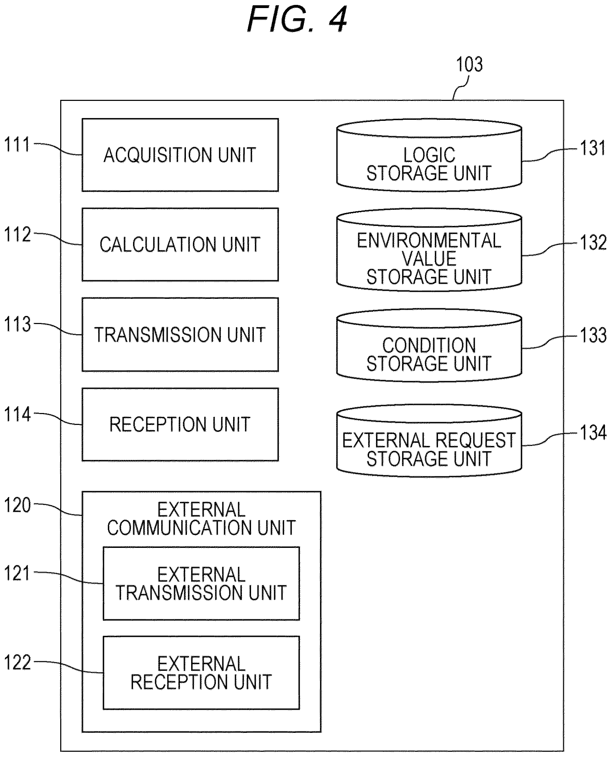

Fig. 4 is a block diagram illustrating a functional configuration of the semiconductor chip 1b that communicates with the outside. The semiconductor chip 1b is configured including an external communication unit 120 and an external request storage unit 134 in addition to each of the functional units of the semiconductor chip 1 illustrated in Fig. 3. The external communication unit 120 further includes an external transmission unit 121 and an external reception unit 122.

The external reception unit 122 receives signals such as environmental value request signals from the external device 90. Furthermore, the external transmission unit 121 transmits signals related to the environmental values detected in the semiconductor module to the external device 90. Note here that the external communication unit 120 including the external transmission unit 121 and the external reception unit 122 may be configured to share hardware such as the coil configuring the transmission unit 113 and the reception unit 114, and the transmission/reception circuit.

The external request storage unit 134 stores environmental value request signals received by the external reception unit 122 from the external device 90. The stored environmental value request signals are transmitted to the adjacent semiconductor chip 1 via the transmission unit 113.

### <Operations>

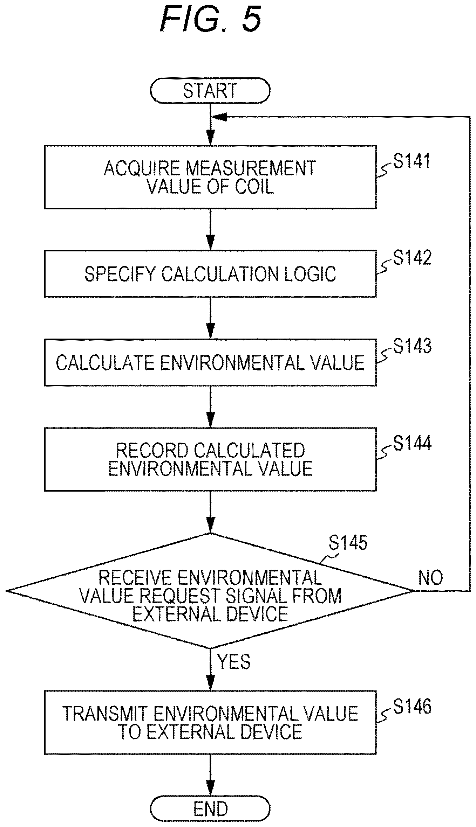

Fig. 5 is a control flowchart for describing a flow of processing according to the embodiment of the present invention.

In the semiconductor chip, the acquisition unit 111 acquires the measurement value (voltage of the coil 70 in the present embodiment) measured by the sensor (S141). Then, the calculation unit 112 specifies the kind of the environmental value corresponding to the condition satisfied among those stored in the condition storage unit 133 and the calculation logic corresponding to the specified kind from the logic storage unit 131 (S142), calculates the environmental value by giving the measurement value to the specified calculation logic (S143), and registers the calculated environmental value in the environmental value storage unit 132 in association with the kind of the environmental value and the time stamp (S144).

When an environmental value request signal is received from the external device (YES at S145), the transmission unit 113 transmits the environmental value registered in the environmental value storage unit 132 to the external device (S146). Note here that the transmission unit 113 may transmit the latest environmental value, or may transmit a history of part of or the entire environmental values.

Hereinafter, a specific example when mounting the semiconductor chip 1 described above on a substrate 100 will be described. In order to mount a plurality of semiconductor chips 1 on the substrate 100 and allow each of the semiconductor chips 1 to function, necessary communication needs to be performed between the semiconductor chips 1, and power needs to be supplied to each of the semiconductor chips 1. In each of the implementation examples described later, specific examples of mounting structures that implement communication and power supply in the semiconductor chips 1 will be described. Note here that communication does not include power supply (for example, wireless power transfer).

### <First Implementation Example>

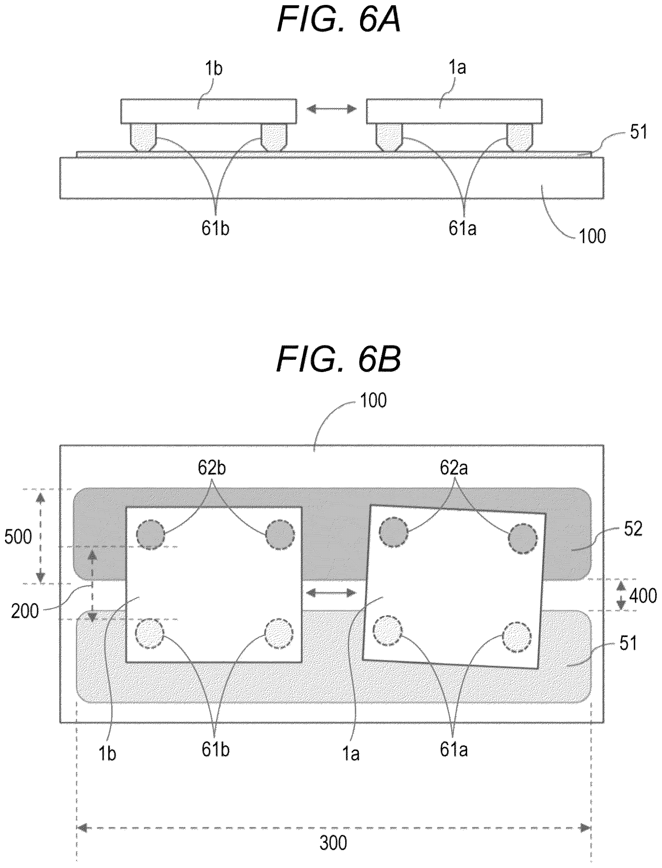

Fig. 6 includes diagrams illustrating a first implementation example in which the semiconductor chip 1 according to the embodiment is mounted on the substrate 100. Fig. 6a illustrates a side view, and Fig. 6b illustrates a plan view. As illustrated in Fig. 6, a power supply area (51) on the negative electrode side and a power supply area (52) on the positive electrode side are provided on one side of the substrate 100. Furthermore, a plurality of the semiconductor chips (1a, 1b) are disposed on one side of the substrate 100, power supply terminals (61) on the negative electrode side of the semiconductor chips are bonded to the power supply area (51) on the negative electrode side, and power supply terminals (62) on the positive electrode side of the semiconductor chips are bonded to the power supply area (52) on the positive electrode side.

Since the semiconductor chip 1 can receive power supplied from the substrate 100 via the power supply terminals (61, 62) of the negative and positive electrodes, and also can perform wireless communication with the other semiconductor chip 1 via the communication unit configured with the coil 70 and the like, the wires connected between the substrate 100 and the semiconductor chip 1 become unnecessary except for the power lines. Thus, it is possible to reduce the number of wires, which are conventionally in several thousand. This simplifies the connection work between the substrate 100 and the semiconductor chip 1, and also makes it possible to use easily deformable materials as the substrate 100.

In the example illustrated in Fig. 6, each of the semiconductor chips 1 is provided with two power supply terminals (61) on the negative electrode side and two power supply terminals (62) on the positive electrode side. Therefore, even when one of the two power supply terminal on the negative electrode sides 61a of the semiconductor chip 1a loses contact with the power supply area (51) on the negative electrode side due to improper bonding work during manufacturing or deformation of the soft substrate 100, for example, the semiconductor chip can acquire the power via the other power supply terminal 61a on the negative electrode side. However, there may not necessarily be two power supply terminals, but may be three or more power supply terminals or may only be a single power supply terminal.

The power supply areas 51, 52 provided on the substrate 100 are areas where the positive electrodes or negative electrodes are exposed, and the power supply terminals in contact with the power supply areas 51, 52 can acquire the power supplied via the power supply areas 51, 52. The power supply area (51) on the negative electrode side and the power supply area (52) on the positive electrode side can be fabricated, for example, with a conductive film or a conductive plate provided on the surface of the substrate 100. Alternatively, those may be fabricated with a layer of conductors when the substrate 100 is formed as a laminated structure of a conductor and a non-conductor. As illustrated in the plan view of Fig. 6b, the power supply area (51) on the negative electrode side and the power supply area (52) on the positive electrode side are provided at neighboring positions with a specific distance (400) provided therebetween so as not to contact each other. Note that the area size of at least one of the positive electrode power supply area 52 and the negative electrode power supply area 51 is generated to be wider than the area size of an end part of at least one of the positive electrode power supply terminal 62 and the negative electrode power supply terminal 61. With such a configuration, in a step of connecting the substrate 100 and the semiconductor chip 1 as a manufacturing step of the semiconductor module, connection between the power supply areas 51, 52 and the power supply terminals 61, 62 can be easily performed even when positioning accuracy is poor. Furthermore, it is desirable for the distance (400) between the positive electrode power supply area 52 and the negative electrode power supply area 51 provided on the substrate 100 to be shorter than a distance (200) between the positive electrode power supply terminals 62 and the negative electrode power supply terminals 61 of the semiconductor chips (1a, 1b). This configuration improves the degree of freedom in the layout positions of the semiconductor chips 1 in the vertical direction in Fig. 6.

Furthermore, a length (500) of the short side of each of the power supply areas 51 and 52 is set to be longer than the width of the power supply terminals (61, 62). With such a configuration, in a step of connecting the substrate 100 and the semiconductor chip 1, connection between the power supply areas 51, 52 and the power supply terminals 61, 62 can be performed without any problems even when positioning accuracy is poor in the direction of the short sides of the power supply areas 51, 52. For example, as illustrated in Fig. 6b, even when the orientation of the semiconductor chip 1a is rotated about 10 degrees relative to the substrate and the other semiconductor chip 1b, the semiconductor chip 1a is connected to the substrate 100 by a power line and has no problem in having wireless communication with the semiconductor chip 1b. Therefore, the degree of difficulty in positioning the semiconductor chips 1 during manufacturing can be lowered, and manufacturing cost can be reduced. Especially, in a case where the semiconductor module is manufactured by connecting the semiconductor chips 1 of 1 mm or 0.5 mm or less in the length of one side on the substrate 100, high positioning accuracy is required to align the positions of the power supply areas 51, 52 and the power supply terminals 61, 62, which generally results in very high manufacturing cost. In such a case, by generating the area size of at least one of the positive electrode power supply area 52 and the negative electrode power supply area 51 to be wider than the area size of an end part of at least one of the positive electrode power supply terminal 62 and the negative electrode power supply terminal 61 as in the present invention, the semiconductor module can be manufactured even when the above-described positioning accuracy is low. Although the present invention can be applied to any semiconductor modules regardless of the sizes of the semiconductor modules, the effect of the present invention is particularly significant when the present invention is applied to small semiconductor chips of 1 mm or 0.5 mm or less in length of one side or to semiconductor modules using such chips.

In a case where a semiconductor chip of 1 mm in the length of one side is used, as an example, the width of the end part of the positive and negative electrode power supply terminals can be set to be about 0.1 mm to 0.3 mm, the distance (200) between the positive electrode power supply terminal 62 and the negative electrode power supply terminal 61 to be about 0.3 mm to 0.7 mm, the distance (400) between the positive electrode power supply area 52 and the negative electrode power supply area 51 to be about 0.1 to 0.6 mm, a longitudinal width (500) of the positive electrode power supply area 52 and the negative electrode power supply area 51 to be 0.2 mm or more, and a horizontal width (300) of the positive electrode power supply area 52 and the negative electrode power supply area 51 (the direction where the chips are disposed) to be 2.1 mm or more.

Commonly known spacing of a plurality of pins (terminals) on the semiconductor chip 1 is a full pitch that is 1/10 inch (2.54 mm), half pitch that is 1/20 inch (1.27 mm), and 1/4 pitch that is 1/40 inch (0.635 mm). Furthermore, 1/8 pitch that is 1/80 inch (0.3175 mm) is expected to be put into practical use. Therefore, at present, the distance (200) between the positive electrode power supply terminal and the negative electrode power supply terminal needs to be set as 0.3 mm or more and, with the width of the positive electrode power supply terminal 62 and the negative electrode power supply terminal 61, the length of one side of the semiconductor chip 1 needs to be set as 0.5 mm or more. On the other hand, a risk of causing short-circuit increases when the distance (400) between the positive electrode power supply area 52 and the negative electrode power supply area 51 is too short. Thus, the distance (400) between each of the areas needs to be set at least as 0.1 mm or more. Furthermore, in the manufacturing steps of the semiconductor module, it is desirable to allow a misalignment of about 0.1 mm as the positioning accuracy of the semiconductor chips 1. Therefore, it is desirable for the distance (400) between the positive electrode power supply area 52 and the negative electrode power supply area 51 to be 0.1 mm or more and to be a value shorter than the distance (200) between the positive electrode power supply terminal 62 and the negative electrode power supply terminal 61. The specific dimensions described above are only implementation examples to which the present invention is applied, and the present invention is not limited to those specific dimensions.

### <Second Implementation Example>

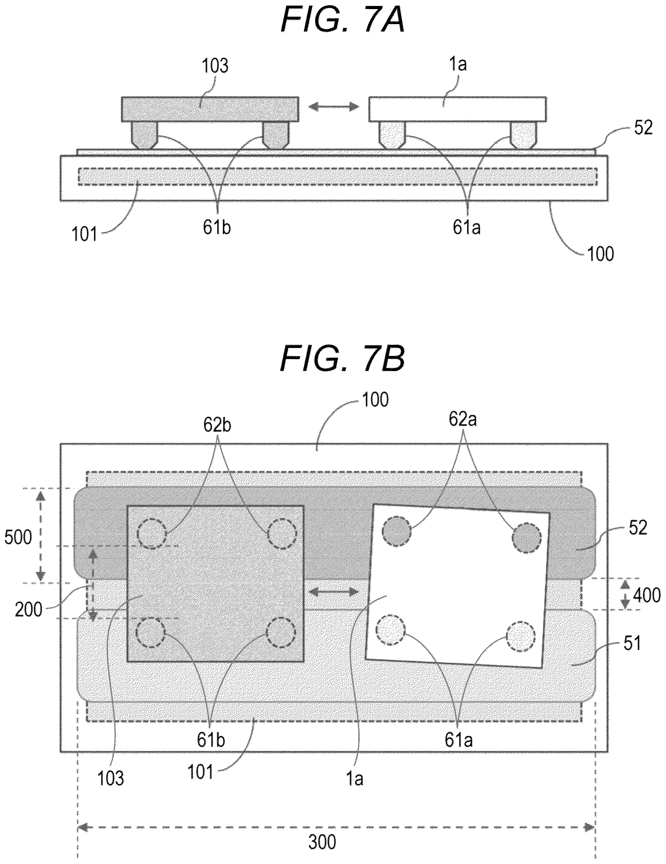

Fig. 7 includes diagrams illustrating a second implementation example in which the semiconductor chip according to the present embodiment is mounted on a material. Fig. 7a illustrates a side view, and Fig. 7b illustrates a plan view. As illustrated in Fig. 7, the power supply area (51) on the negative electrode side and the power supply area (52) on the positive electrode side are provided on one side of a material 100 where the semiconductor chip is mounted, that is, on one side of the substrate 100. Furthermore, the semiconductor chips (1a, 1b) are disposed on one side of the material 100, the power supply terminals (61) on the negative electrode side of the semiconductor chips are bonded to the power supply area (51) on the negative electrode side, and the power supply terminals (62) on the positive electrode side of the semiconductor chips are bonded to the power supply area (52) on the positive electrode side.

Furthermore, a power supply element 101 capable of generating or storing electricity is mounted on the material 100, and the power supply element 101 can supply power to each of the semiconductor chips via the power supply areas (51, 52) and the power supply terminals (61, 62) of the negative and positive electrodes. Note here that the power supply element 101 can be configured with a power generation element that generates electricity, such as power generation by sunlight or power generation by vibration, or configured with a power storage element including a primary battery or a secondary battery that stores power, such as a lithium-ion battery or a lead-acid battery. Furthermore, each of the semiconductor chips can perform wireless communication mutually via a communication unit configured with the coil 70 or the like. Moreover, by forming at least one of the semiconductor chips as a semiconductor chip 103 that has an external communication function that enables wireless communication with external devices, a semiconductor module having the semiconductor chips and the material can perform wireless communication with the external devices. With such a configuration, the wires connected between the material and the semiconductor chips become unnecessary except for the power lines. Thus, it is possible to reduce the number of wires, which are conventionally in several thousand. This simplifies the connection work between the material and the semiconductor chips, and also makes it possible to mount the semiconductor chips on an easily deformable material.

In the example shown in Fig. 7, each of the semiconductor chips is provided with two power supply terminals (61) on the negative electrode side and two power supply terminals (62) on the positive electrode side. Therefore, even when one of the two power supply terminal on the negative electrode sides 61a of the semiconductor chip 1a loses contact with the power supply area (51) on the negative electrode side due to improper bonding work during manufacturing or deformation of the soft material, for example, the semiconductor chip can acquire the power via the other power supply terminal 61a on the negative electrode side. However, there may not necessarily be two power supply terminals, but may be three or more power supply terminals or may only be a single power supply terminal.

The power supply areas provided on the material are areas where the positive electrodes or negative electrodes are exposed, and the power supply terminals in contact with the power supply areas can acquire the power supplied via the power supply areas. The power supply area (51) on the negative electrode side and the power supply area (52) on the positive electrode side can be fabricated, for example, with a conductive film or a conductive plate provided on the surface of the material. Alternatively, those may be fabricated with a layer of conductors when the material is formed as a laminated structure of a conductor and a non-conductor. As illustrated in the plan view of Fig. 7b, the power supply area (51) on the negative electrode side and the power supply area (52) on the positive electrode side are provided at adjacent positions with the specific distance (400) provided therebetween so as not to contact each other. Note here that the area size of at least one of the positive electrode power supply area and the negative electrode power supply area is generated to be wider than the area size of an end part of at least one of the positive electrode power supply terminal and the negative electrode power supply terminal. With such a configuration, in a step of connecting the material and the semiconductor chips as a manufacturing step of the semiconductor module, connection between the power supply areas and the power supply terminals can be easily performed even when positioning accuracy is poor. Furthermore, it is desirable for the distance (400) between the positive electrode power supply area and the negative electrode power supply area provided on the material to be shorter than a distance (200) between the positive electrode power supply terminal and the negative electrode power supply terminal of the semiconductor chips (1a, 1b). This configuration improves the degree of freedom in the layout positions of the semiconductor chips in the vertical direction in Fig. 7b.

Furthermore, the length (500) of the short side of each of the power supply areas is set to be longer than the width of the power supply terminals (61, 62). With such a configuration, in a step of connecting the material and the semiconductor chips, connection between the power supply areas and the power supply terminals can be performed without any problems even when positioning accuracy is poor in the direction of the short sides of the power supply areas. For example, as illustrated in Fig. 7b, even when the orientation of the semiconductor chip 1a is rotated about 10 degrees relative to the material and the other semiconductor chip 103, the semiconductor chip 1a is connected to the material by the power line and has no problem in having wireless communication with the semiconductor chip 103. Therefore, the degree of difficulty in positioning the semiconductor chips during manufacturing can be lowered, and manufacturing cost can be reduced. Especially, in a case where the semiconductor module is manufactured by connecting the semiconductor chips of 1 mm or 0.5 mm or less in the length of one side on the material, high positioning accuracy is required to align the positions of the power supply areas and the power supply terminals, which generally results in very high manufacturing cost. In such a case, by generating the area size of at least one of the positive electrode power supply area and the negative electrode power supply area to be wider than the area size of an end part of at least one of the positive electrode power supply terminal and the negative electrode power supply terminal as in the present invention, the semiconductor module can be manufactured even when the above-described positioning accuracy is low. Although the present invention can be applied to any semiconductor modules regardless of the sizes of the semiconductor modules, the effect of the present invention is particularly significant when the present invention is applied to small semiconductor chips of 1 mm or 0.5 mm or less in length of one side or to semiconductor modules using such chips.

In a case where a semiconductor chip of 1 mm in the length of one side is used, as an example, the width of the end part of the positive and negative electrode power supply terminals can be set to be about 0.1 mm to 0.3 mm, the distance (200) between the positive electrode power supply terminal and the negative electrode power supply terminal to be about 0.3 mm to 0.7 mm, the distance (400) between the positive electrode power supply area and the negative electrode power supply area to be about 0.1 to 0.6 mm, the longitudinal width (500) of the positive electrode power supply area and the negative electrode power supply area to be 0.2 mm or more, and the horizontal width (300) of the positive electrode power supply area and the negative electrode power supply area (the direction where the chips are disposed) to be 2.1 mm or more.

Commonly known spacing of a plurality of pins (terminals) on the semiconductor chip is a full pitch that is 1/10 inch (2.54 mm), half pitch that is 1/20 inch (1.27 mm), and 1/4 pitch that is 1/40 inch (0.635 mm). Furthermore, 1/8 pitch that is 1/80 inch (0.3175 mm) is expected to be put into practical use. Therefore, at present, the distance (200) between the positive electrode power supply terminal and the negative electrode power supply terminal needs to be set as 0.3 mm or more and, with the width of the positive electrode power supply terminal and the negative electrode power supply terminal, the length of one side of the semiconductor chip needs to be set as 0.5 mm or more. On the other hand, a risk of causing short-circuit increases when the distance (400) between the positive electrode power supply area and the negative electrode power supply area is too short. Thus, the distance (400) between each of the areas needs to be set at least as 0.1 mm or more. Furthermore, in the manufacturing steps of the semiconductor module, it is desirable to allow a misalignment of about 0.1 mm as the positioning accuracy of the semiconductor chips. Therefore, it is desirable for the distance (400) between the positive electrode power supply area and the negative electrode power supply area to be 0.1 mm or more and to be a value shorter than the distance (200) between the positive electrode power supply terminal and the negative electrode power supply terminal. The specific dimensions described above are only implementation examples to which the present invention is applied, and the present invention is not limited to those specific dimensions.

### <Third Implementation Example>

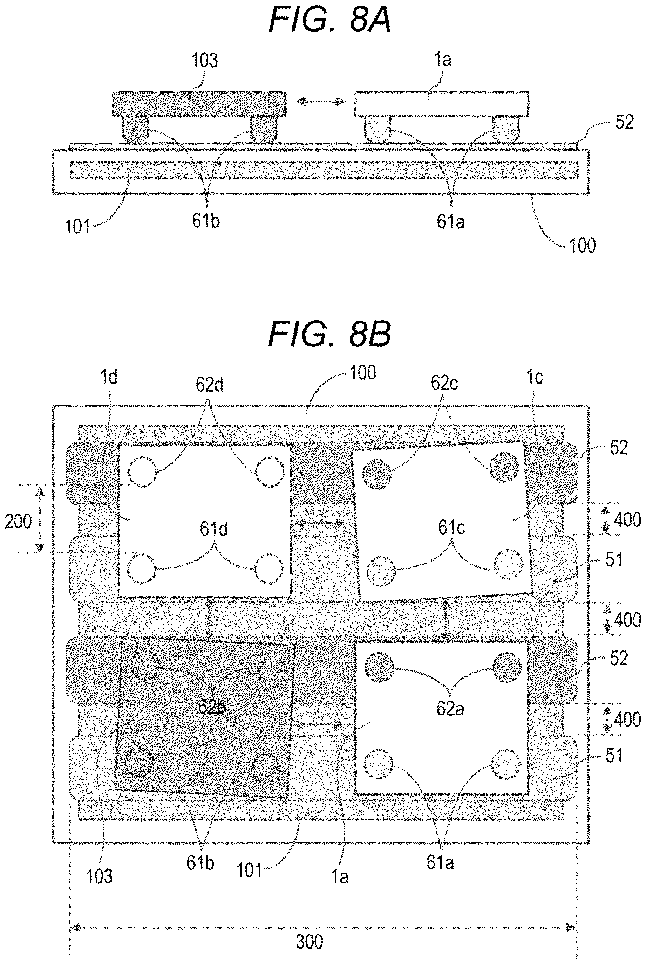

Fig. 8 includes diagrams illustrating a third implementation example in which the semiconductor chip according to the present embodiment is mounted on a material. Fig. 8a illustrates a side view, and Fig. 8b illustrates a plan view. As illustrated in the plan view of Fig. 8, the power supply area (51) on the negative electrode side and the power supply area (52) on the positive electrode side are provided on one side of the material 100. Furthermore, a plurality of semiconductor chips (1a, 103, 1c, 1d) are disposed on one side of the material 100, the power supply terminals (61) on the negative electrode side of the semiconductor chips are bonded to the power supply area (51) on the negative electrode side, and the power supply terminals (62) on the positive electrode side of the semiconductor chips are bonded to the power supply area (52) on the positive electrode side. Herein, unlike the second implementation example illustrated in Fig. 7, the power supply area (51) on the negative electrode side and the power supply area (52) on the positive electrode side are provided alternately at a plurality of sections on one side of the material 100. Therefore, it is possible to acquire power from the material by disposing the semiconductor chips at a certain position on the boundary between the power supply areas (51) on the negative electrode side and the power supply areas (52) on the positive electrode side, thereby increasing the degree of freedom in the layout positions when disposing the semiconductor chips on the material.

Furthermore, the power supply element 101 capable of generating or storing electricity is mounted on the material 100, and the power supply element 101 can supply power to each of the semiconductor chips via the power supply areas (51, 52) and the power supply terminals (61, 62) of the negative and positive electrodes. Furthermore, each of the semiconductor chips can perform wireless communication mutually via the communication unit configured with the coil 70 or the like. Moreover, by forming at least one of the semiconductor chips as the semiconductor chip 103 that has the external communication function that enables wireless communication with external devices, a semiconductor module having the semiconductor chips and the material can perform wireless communication with the external devices. With such a configuration, the wires connected between the material and the semiconductor chips become unnecessary except for the power lines. Thus, it is possible to reduce the number of wires, which are conventionally in several thousand. This simplifies the connection work between the material and the semiconductor chips, and also makes it possible to mount the semiconductor chips on an easily deformable material.

### <Fourth Implementation Example>

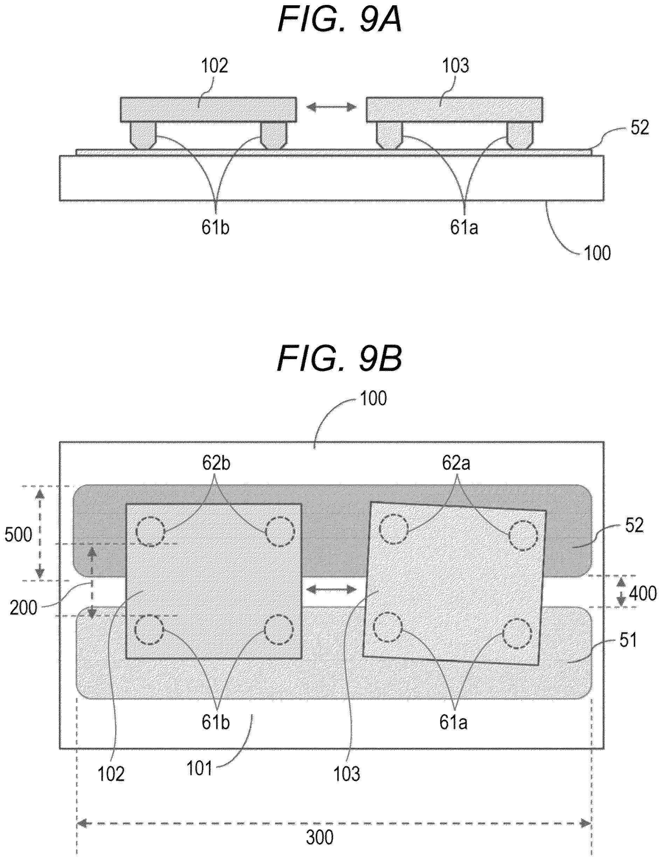

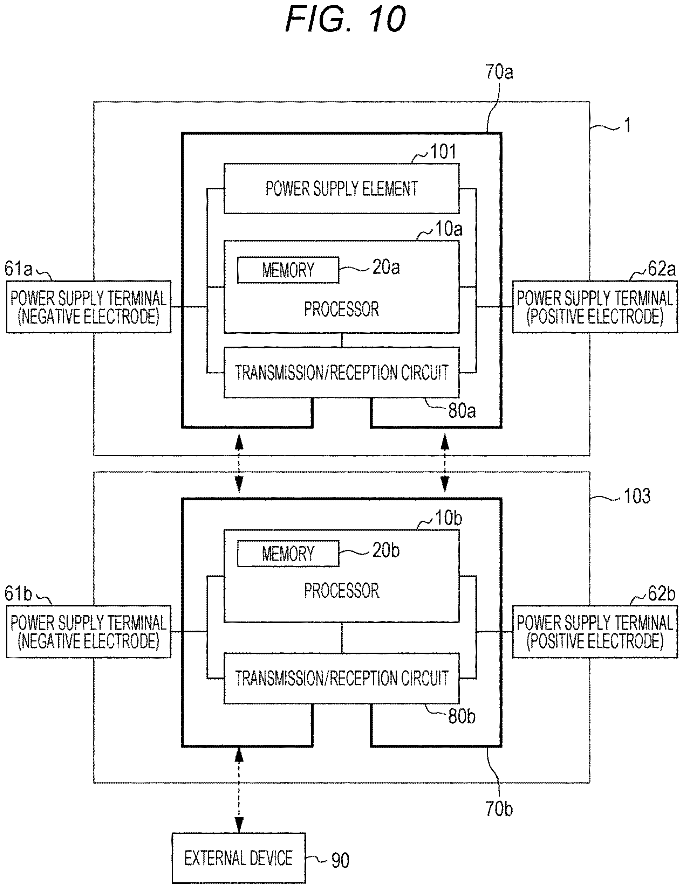

Fig. 9 includes diagrams illustrating a fourth implementation example in which the semiconductor chip according to the present embodiment is mounted on a material. Fig. 9a illustrates a side view, and Fig. 9b illustrates a plan view. Furthermore, Fig. 10 is a diagram illustrating a hardware configuration of the semiconductor chip according to the fourth implementation example. As illustrated in the plan view of Fig. 9, the power supply area (51) on the negative electrode side and the power supply area (52) on the positive electrode side are provided on one side of the material 100. Furthermore, a plurality of semiconductor chips (102, 103) are disposed on one side of the material 100, the power supply terminals (61) on the negative electrode side of the semiconductor chips are bonded to the power supply area (51) on the negative electrode side, and the power supply terminals (62) on the positive electrode side of the semiconductor chips are bonded to the power supply area (52) on the positive electrode side.

Furthermore, in the fourth implementation example, the power supply element 101 is mounted not on the material side but on the semiconductor chip 102, and the power supply element 101 supplies power to the processor and the transmission/reception circuit in the semiconductor chip 102 as well as to the material side via the power supply terminals (61, 62), and further supplies power to the other semiconductor chip 103 mounted on the material via the power supply areas (51, 52) provided on the material side. Furthermore, each of the semiconductor chips performs wireless communication mutually via the communication unit configured with the coil 70 or the like and, further, by forming at least one of the semiconductor chips as the semiconductor chip 103 that has an external communication function that enables wireless communication with external devices, a semiconductor module having the semiconductor chips and the material can perform wireless communication with the external devices. With such a configuration, the wires connected between the material and the semiconductor chips become unnecessary except for the power lines. Thus, it is possible to reduce the number of wires, which are conventionally in several thousand. This simplifies the connection work between the material and the semiconductor chips, and also makes it possible to mount the semiconductor chips on an easily deformable material.

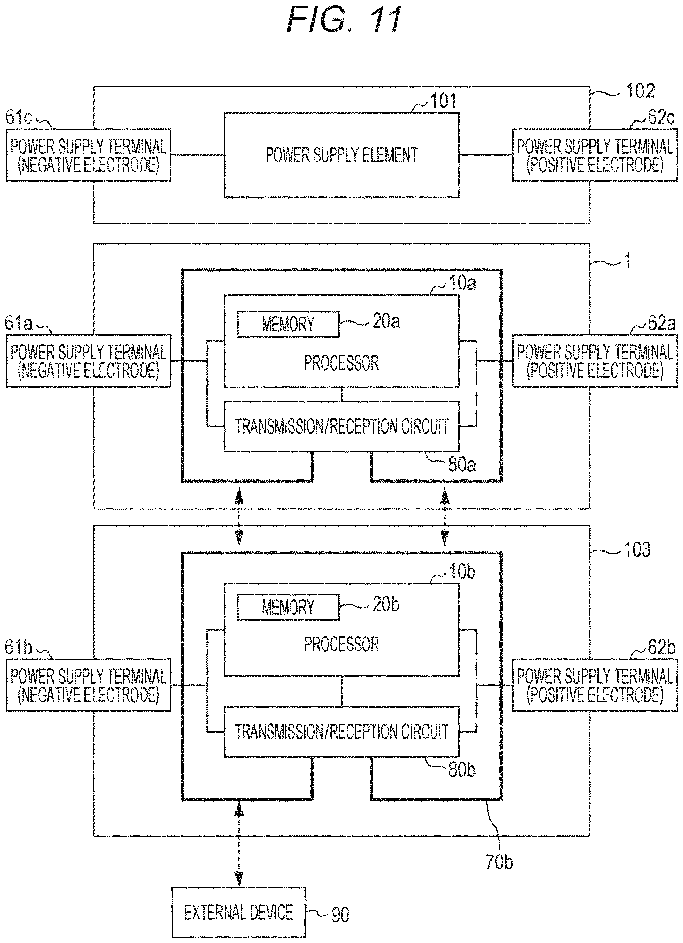

Note here that Fig. 11 is a hardware configuration diagram illustrating another example of the fourth implementation example. As illustrated in Fig. 11, the semiconductor chip 102 having the power supply element 101 does not necessarily need to have the same functions as those of the semiconductor chip 1. It can be configured to include the power supply element 101 and the power supply terminals (61, 62), which are necessary structures to supply power to the material side, and not to include a processor, a transmission/reception circuit, and a coil. In this case, the power supplied from the semiconductor chip 102 is supplied to the other semiconductor chips 1 and 103 via the power supply areas (51, 52) on the material side.

### <Fifth Implementation Example>

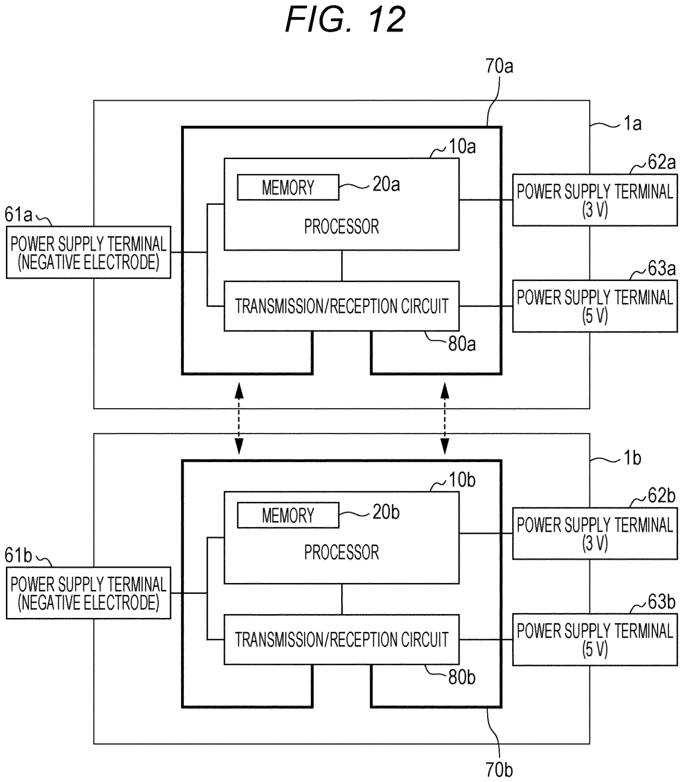

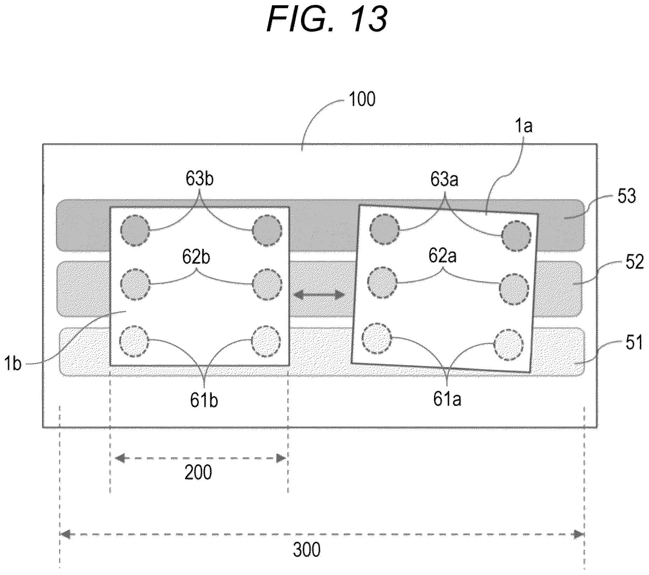

Referring to Fig. 12 and Fig. 13, an implementation example in which a plurality of levels of voltage are supplied to the semiconductor chip 1 will be described. Fig. 12 illustrates a configuration example different from that of Fig. 2, which is a hardware configuration in which the coil 70 is applied as an example where the sensing unit S30 and the communication unit 40 are mounted. It differs from the example illustrated in Fig. 2 in respect that the power supply terminals are configured with three kinds that are a negative electrode power supply terminal 61, a first positive electrode power supply terminal (low voltage) 62, and a second positive electrode power supply terminal (high voltage) 63. The first positive electrode power supply terminal 62 is connected to a power supply that supplies a voltage of 3 V, for example, and the second positive electrode power supply terminal 63 is connected to a power supply that supplies a voltage of 5 V, for example, which is a higher voltage than that of the first positive electrode power supply terminal 62. The negative electrode power supply terminal 61 is a common power supply terminal connected to both of the processor and the transmission/reception circuit; the first positive electrode power supply terminal 62 is connected to a functional unit requiring a lower voltage power supply (for example, the processor), and the second positive electrode power supply terminal 63 is connected to a functional unit requiring a higher voltage power supply (for example, the transmission/reception circuit).

Fig. 13 is a diagram illustrating a fifth implementation example in which the semiconductor chip 1 according to the present embodiment is mounted on the substrate 100. As illustrated in the plan view of Fig. 13, the power supply area (51) on the negative electrode side, the first power supply area (52) on the positive electrode side, and the second power supply area (53) on the positive electrode side are provided on one side of the substrate 100. Furthermore, a plurality of the semiconductor chips (1a, 1b) are disposed on one side of the substrate 100, the power supply terminals (61) on the negative electrode side of the semiconductor chips are bonded to the power supply area (51) on the negative electrode side, and the first power supply terminals (62) on the positive electrode side of the semiconductor chips are bonded to the first power supply area (52) on the positive electrode side, and the second power supply terminals (63) on the positive electrode side of the semiconductor chips are bonded to the second power supply area (53) on the positive electrode side. The first power supply area (52) on the positive electrode side is connected to the power supply that supplies a voltage of 3 V, for example, and the second power supply area (53) on the positive electrode side is connected to the power supply that supplies a voltage of 5 V, for example, which is a higher voltage than that of the first positive electrode power supply area (52).

Even in a case where the semiconductor chip 1 requires a plurality of levels of voltage as in the implementation example illustrated in Fig. 12 and Fig. 13, by providing the power supply areas (51, 52, 53) corresponding to each level of voltage on the substrate 100 as illustrated in Fig. 13, the degree of difficulty in positioning the semiconductor chips during manufacturing can be lowered, and manufacturing cost can be reduced.

### <Sixth Implementation Example>

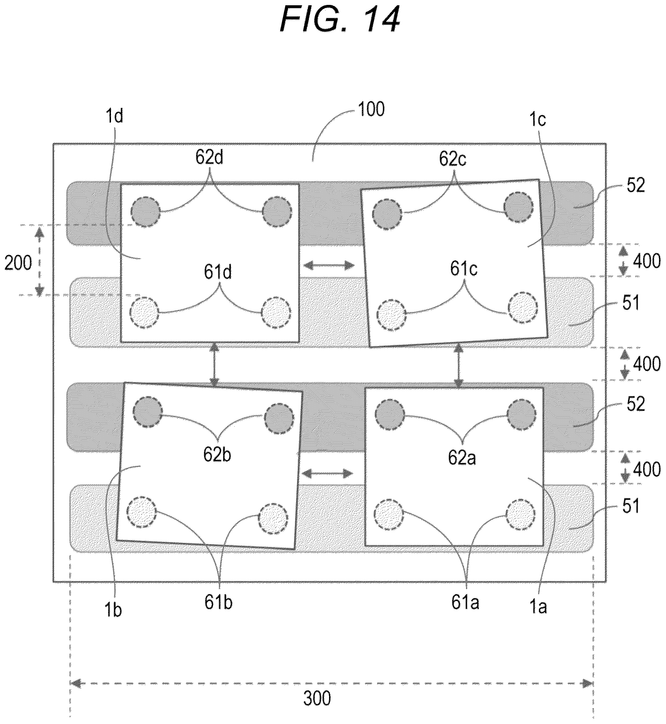

Fig. 14 is a diagram illustrating a sixth implementation example in which the semiconductor chip according to the present embodiment is mounted on the substrate 100. As illustrated in the plan view of Fig. 14, the power supply area (51) on the negative electrode side and the power supply area (52) on the positive electrode side are provided on one side of the substrate 100. Furthermore, a plurality of the semiconductor chips (1a, 1b) are disposed on one side of the substrate 100, the power supply terminals (61) on the negative electrode side of the semiconductor chips are bonded to the power supply area (51) on the negative electrode side, and the power supply terminals (62) on the positive electrode side of the semiconductor chips are bonded to the power supply area (52) on the positive electrode side. Herein, unlike the first implementation example illustrated in Fig. 6, the power supply area (51) on the negative electrode side and the power supply area (52) on the positive electrode side are provided alternately at a plurality of sections on one side of the substrate 100. Therefore, it is possible to acquire the power from the substrate 100 by disposing the semiconductor chips at a certain position on the boundaries between the power supply areas (51) on the negative electrode side and the power supply areas (52) on the positive electrode side, thereby increasing the degree of freedom in the layout positions when disposing the semiconductor chips 1 on the substrate 100.

### <Seventh Implementation Example>

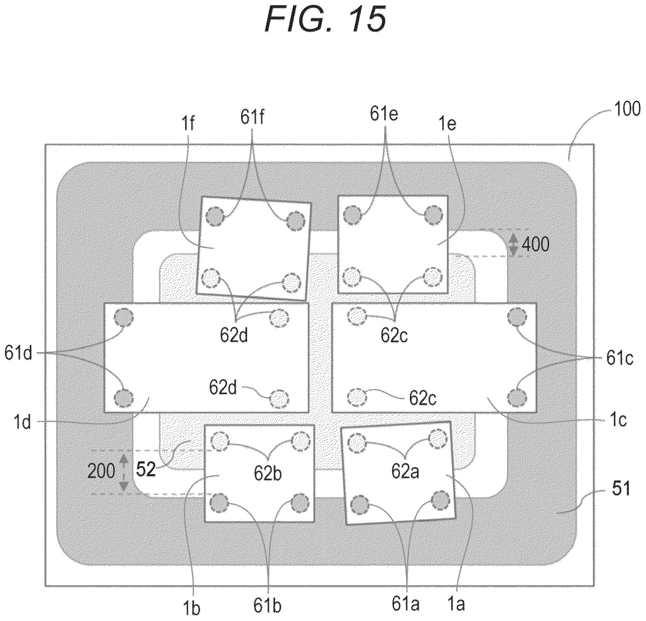

Fig. 15 is a diagram illustrating a seventh implementation example in which the semiconductor chip 1 according to the present embodiment is mounted on the substrate 100. As illustrated in the plan view of Fig. 15, the power supply area (51) on the negative electrode side and the power supply area (52) on the positive electrode side are provided on one side of the substrate 100. Furthermore, a plurality of the semiconductor chips (1a, 1b, 1c, 1d, 1e, 1f) are disposed on one side of the substrate 100, the power supply terminals (61) on the negative electrode side of the semiconductor chips are bonded to the power supply area (51) on the negative electrode side, and the power supply terminals (62) on the positive electrode side of the semiconductor chips are bonded to the power supply area (52) on the positive electrode side. Herein, unlike the sixth implementation example illustrated in Fig. 14, on one side of the substrate 100, the power supply area (51) on the negative electrode side and the power supply area (52) on the positive electrode side are provided adjacently with the specific distance (400) provided therebetween so as not to contact each other in such a manner that one of those areas is disposed on the inner side and the other is disposed at a position surrounding the periphery of the inner one. Therefore, it is possible to acquire the power from the substrate 100 by disposing the semiconductor chips 1 at a certain position on the boundary between the power supply area (51) on the negative electrode side and the power supply area (52) on the positive electrode side, thereby increasing the degree of freedom in the layout positions when disposing the semiconductor chips 1 on the substrate 100.

### <Eighth Implementation Example>

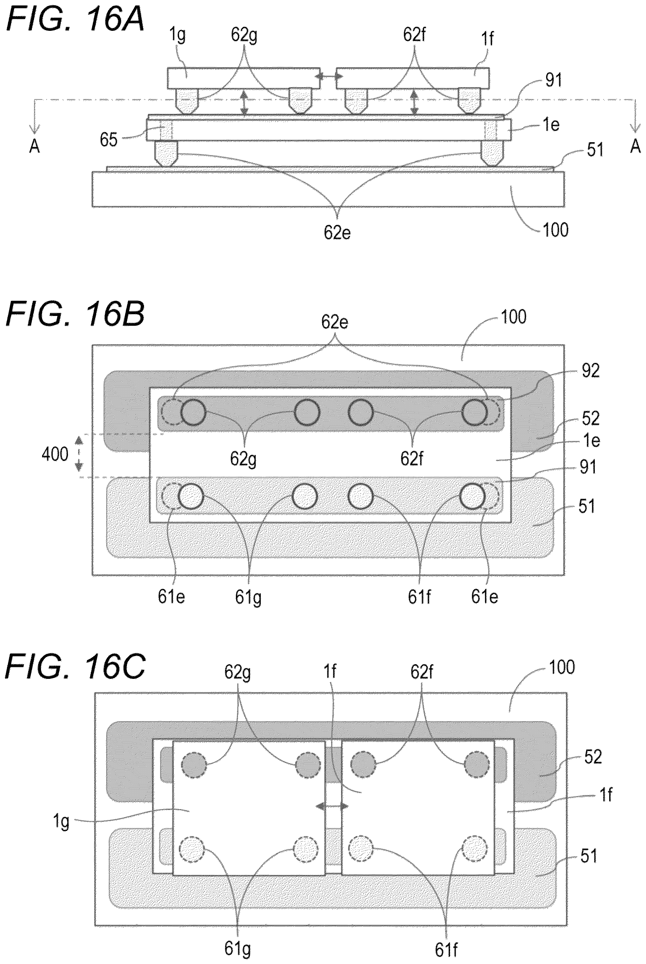

Fig. 16 includes diagrams illustrating an eighth implementation example in which the semiconductor chip 1 according to the present embodiment is mounted on the substrate 100. Fig. 16a illustrates a side view, Fig. 16b illustrates a sectional view taken along A-A line, and Fig. 16c illustrates a plan view. As illustrated in Fig. 16, the power supply area (51) on the negative electrode side and the power supply area (52) on the positive electrode side are provided on one side (upper side) of the substrate 100. Furthermore, a semiconductor chip (1e) is disposed on one side (upper side) of the substrate 100, power supply terminals (61e) on the negative electrode side of the semiconductor chip (1e) are bonded to the power supply area (51) on the negative electrode side of the substrate, and power supply terminals (62e) on the positive electrode side of the semiconductor chip (1e) are bonded to the power supply area (52) on the positive electrode side of the substrate 100. Here, unlike the implementation examples described above, the semiconductor chip (1e) that is in contact with the substrate 100 via the power supply areas includes, on the upper side of the chip opposite from the lower side of the chip where the power supply terminals (61e, 62e) are provided, a negative electrode area (91) where the negative electrodes are exposed and a positive electrode area (92) where the positive electrodes are exposed are provided. The negative electrode area (91) and the positive electrode area (92) are provided adjacently with the specific distance (400) provided therebetween so as not to contact each other. The negative electrode area (91) of the semiconductor chip (1e) is electrically connected to the negative electrode power supply terminals (61e) via a negative electrode conductive part 65 provided in the semiconductor chip (1e), and the positive electrode area (92) of the semiconductor chip (1e) is electrically connected to the power supply terminals (62e) via a positive electrode conductive part 65 provided in the semiconductor chip (1e), and electrically connected to the power supply of the substrate.

Furthermore, on the upper side of the semiconductor chip (1e), semiconductor chips (1f, 1g) are further provided. Power supply terminals (61f, 61g) on the negative electrode side of the semiconductor chips (1f, 1g) are bonded to the negative electrode area (91) of the semiconductor chip (1e), and power supply terminals (62f, 62g) on the positive electrode side of the semiconductor chips (1f, 1g) are bonded to the positive electrode area (92) of the semiconductor chip (1e). As described, even in a case where the semiconductor chips are disposed in a plurality of layers on the substrate, semiconductor chips (1f, 1g) that are not in direct contact with the substrate can also acquire power from the substrate via the semiconductor chip (1e) that is in direct contact with the substrate. Furthermore, since each of the semiconductor chips (1e, 1f, 1g) is adjacent to each other, it is possible to perform communication with each other by the communication unit 40 configured with the coil 70 or the like. Thus, there is no need for some of the semiconductor chips to be in direct contact with the substrate, thereby improving the degree of freedom in the layout of the semiconductor chips when manufacturing an information processing device with a plurality of semiconductor chips.

### <Ninth Implementation Example>

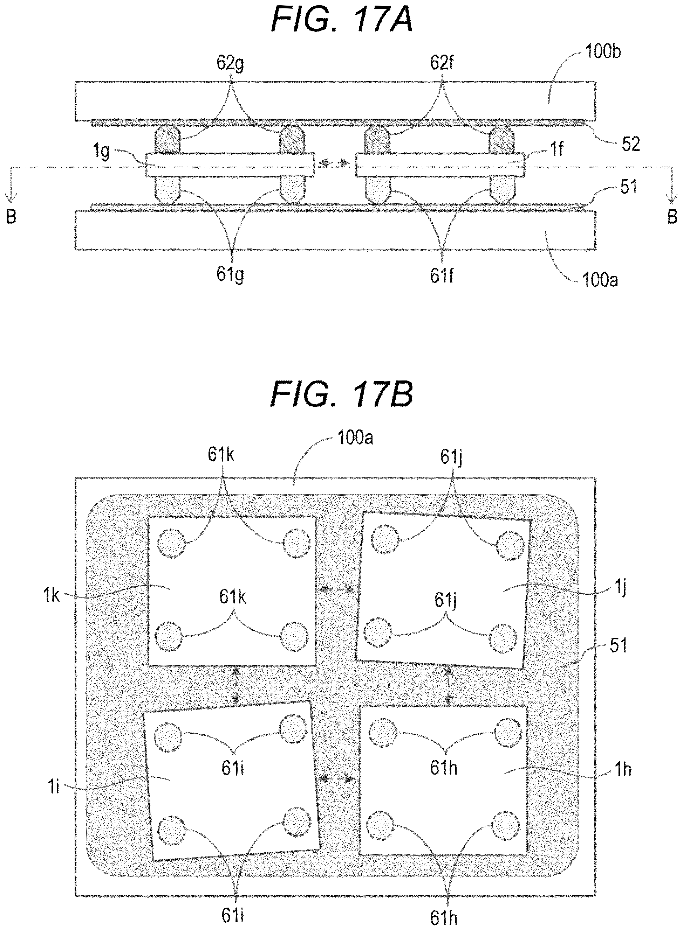

Fig. 17 includes diagrams illustrating a ninth implementation example in which the semiconductor chip 1 according to the present embodiment is mounted on the substrate 100. Fig. 17a illustrates a side view, and Fig. 17b illustrates a sectional view taken along B-B line. As illustrated in Fig. 17, semiconductor chips (1h, 1i, 1j, 1k) are provided at positions sandwiched by a plurality of substrates (100a, 100b) from both sides. The power supply area (51) on the negative electrode side is provided on the top face (face on the semiconductor chip 1 side) of the substrate 100a on the lower side. On the other hand, the power supply area (52) on the positive electrode side is provided on the bottom face (face on the semiconductor chip 1 side) of the substrate 100b on the upper side. Furthermore, each of the semiconductor chips (1h, 1i, 1j, 1k) disposed between the substrate 100a and the substrate 100b includes the power supply terminal (61) on the negative electrode side on one side and the power supply terminal (62) on the positive electrode side on the other side.

The semiconductor chips (1h, 1i, 1j, 1k) can receive power supplied from each of the substrates (100a, 100b) by being sandwiched between the two substrates (100a, 100b) in a state where the power supply terminals (61) on the negative electrode side are in contact with the power supply area (51) of the substrate 100a and the power supply terminals (62) on the positive electrode side are in contact with the power supply area (52) of the substrate 100b. Furthermore, since the power supply area (51) on the negative electrode side is provided on the substrate 100a and the power supply area (52) on the positive electrode side is provided on the substrate 100b, it is not necessary to provide two power supply areas of the positive electrode and negative electrode on a single substrate and not necessary to provide a space between the power supply areas (51, 52). Thus, it is possible to provide the power supply areas (51, 52) almost on the whole face of the substrates (100a, 100b). Therefore, the power supply terminals (61, 62) and the power supply areas (51, 52) come in contact no matter where the semiconductor chips 1 are disposed on the substrates (100a, 100b), so that it is not necessary to dispose the semiconductor chips 1 at prescribed positions with high precision at the time of manufacturing.

Furthermore, when the substrates (100a, 100b) are formed with a soft material, the contact positions of the power supply areas (51, 52) of the substrates (100a, 100b) and the power supply terminals (61, 62) of the semiconductor chip 1 may be shifted due to the curved deformation of the substrates (100a, 100b). However, even in such a case, the semiconductor chip 1 can remain in contact with the power supply areas (51, 52) and continue to acquire the power supply, since the power supply areas (51, 52) are widely formed on the faces of the substrates (100a, 100b).

### <Tenth Implementation Example>

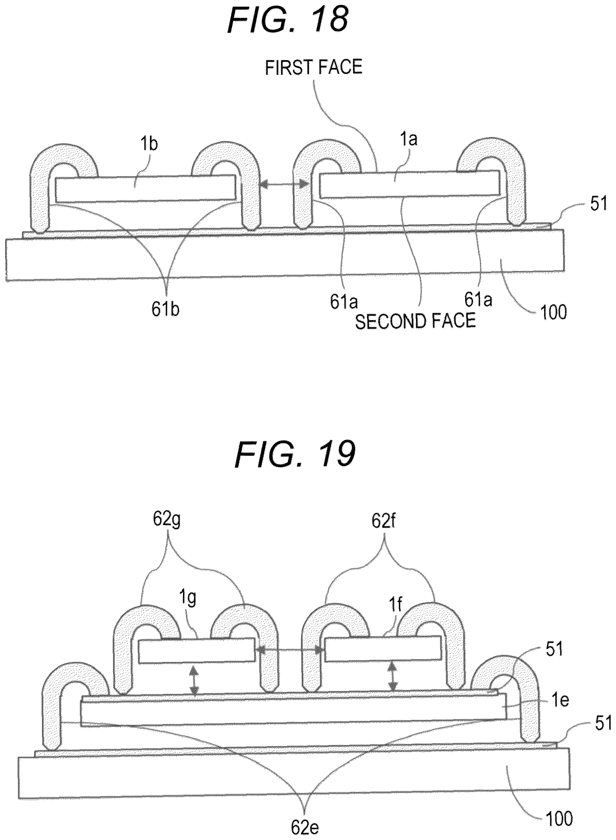

Fig. 18 is a diagram illustrating a tenth implementation example in which the semiconductor chip 1 according to the present embodiment is mounted on the substrate 100. The implementation examples above are described by referring to the case where the power supply terminals (61, 62) are provided on a first face (one side) of the semiconductor chip 1 and contact the substrate 100 on the first face side. However, as illustrated in Fig. 18, the power supply terminals (61, 62) may be configured to extend from the first face of the semiconductor chip 1 to a second face through the side face of the semiconductor chip 1 to be connected to the substrate 100 positioned on the second face side of the semiconductor chip 1.

### <Eleventh Implementation Example>

Fig. 19 is a diagram illustrating an eleventh implementation example in which the semiconductor chip 1 according to the present embodiment is mounted on the substrate 100. The implementation example illustrated in Fig. 16 is described by referring to the case where the power supply terminals (61, 62) are provided on the first face (one side) of the semiconductor chip (1e), and the positive electrode area and the negative electrode area are provided on the second face (the other side). However, as illustrated in Fig. 19, the power supply terminals (61, 62), the positive electrode power supply area (52), and the negative electrode power supply area (51) may be provided on the first face (one side) of the semiconductor chip (1e), and the power supply terminals (61, 62) may be configured to extend from the first face of the semiconductor chip (1e) to the second face through the side face of the semiconductor chip (1e) to be connected to the substrate 100 positioned on the second face side of the semiconductor chip (1e) or the other semiconductor chips.

### <Manufacturing Method>

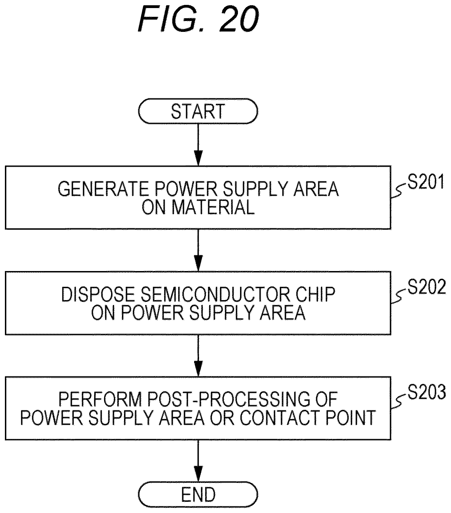

Fig. 20 is a flowchart illustrating manufacturing steps of a semiconductor chip module according to the present embodiment. As the manufacturing steps of the semiconductor chip module, first, the power supply areas (51, 52) where the electrodes are exposed are generated on the substrate 100 (step 201). The power supply areas (51, 52) generated on the surface of the substrate 100 in this step may be generated, for example, by applying a conductive coating or by attaching a conductive adhesive sheet to the substrate 100. Alternatively, it can also be generated by attaching a conductive film material such as a metallic film to the surface of a material.

As a next step, the semiconductor chip 1 is disposed on the power supply areas (51, 52) (step 202). In this step, the semiconductor chip 1 is disposed at a position where the positive electrode power supply terminal (62) of the semiconductor chip 1 contacts the positive electrode power supply area (52) and the negative electrode power supply terminal (61) contacts the negative electrode power supply area (51). Here, when the power supply areas (51, 52) are generated by applying a conductive coating at step 201, the power supply areas (51, 52) and the power supply terminals (61, 62) can be bonded by bringing the positive electrode power supply terminal 62 and negative electrode power supply terminal 61 into contact with the coating before the coating is dried or cured. Alternatively, when the power supply areas (51, 52) are generated by attaching a conductive adhesive sheet to the substrate 100 at step 201, the power supply areas (51, 52) and the power supply terminals (61, 62) can be bonded by bringing the positive electrode power supply terminal 62 and negative electrode power supply terminal 61 into contact with the adhesive sheet while the adhesiveness of the adhesive sheet is being maintained. Since the area size of at least one of the positive electrode power supply area 52 and the negative electrode power supply area 51 is generated to be wider than the area size of an end part of at least one of the positive electrode power supply terminal 62 and the negative electrode power supply terminal 61, it is unnecessary to increase the positioning precision when disposing the semiconductor chip 1 in this step.

As a next step, post-processing of the power supply areas (51, 52) or the contact points is performed (step 203). Here, when the power supply areas (51, 52) are generated by applying a conductive coating at step 201, it is desirable to cure or dry the coating to provide a state where it is difficult for impurities to be bonded in order to prevent short-circuit from occurring due to the impurities bonded between the positive electrode power supply area (52) and the negative electrode power supply area (51). Specifically, the coating is cured or dried by blowing air using a fan, by heating, or by applying light rays such as ultraviolet rays. Alternatively, even when the power supply areas (51, 52) are generated by attaching a conductive adhesive sheet to the substrate at step 201, it is desirable to decrease the adhesive power of the adhesive sheet to provide a state where it is difficult for impurities to be bonded in order to prevent short-circuit from occurring due to the impurities bonded between the positive electrode power supply area (52) and the negative electrode power supply area (51). Specifically, the adhesive power of the adhesive sheet is decreased by blowing air using a fan, by heating, or by applying light rays such as ultraviolet rays.

The implementation examples above are described by referring to the case where the area size of at least one of the positive electrode power supply area 52 and the negative electrode power supply area 51 is generated to be wider than the area size of an end part of at least one of the positive electrode power supply terminal 62 and the negative electrode power supply terminal 61. With such a configuration, in a step of connecting the substrate 100 and the semiconductor chip 1, even when the positioning accuracy is poor in the direction of the long side in each of the power supply areas (51, 52), the layout may simply need to be determined such that the power supply areas (51, 52) and the power supply terminals (61, 62) can be connected and that the adjacent semiconductor chips 1 are disposed within a distance range communicable with each other. Furthermore, the implementation examples above are described by referring to the case where the distance (400) between the positive electrode power supply area 52 and the negative electrode power supply area 51 provided on the substrate 100 is set to be shorter than the distance (200) between the positive electrode power supply terminal 62 and the negative electrode power supply terminal 61 of the semiconductor chips (1a, 1b). This configuration improves the degree of freedom in the layout positions of the semiconductor chips 1.

Moreover, the implementation examples above are described by referring to the case where the power supply areas (areas where the electrodes are exposed) are provided on the surface of the substrate 100 or the semiconductor chip 1. However, in order to prevent the negative electrode and positive electrode power supply areas (51, 52) from temporarily or regularly short-circuiting due to contamination of foreign matters, the substrate 100 after the semiconductor chips 1 are being bonded and the semiconductor chip module configured with the semiconductor chips 1 may be sealed (molded) by resin.

In each of the implementation examples described above, for the substrate 100, it is possible to apply a hardware material with low flexibility, such as conventional semiconductor substrates, and it is also possible to apply a soft material with high flexibility such as a flexible substrate or fabric. Furthermore, while each of the implementation example is described by referring to the case where the semiconductor chips 1 are bonded to the common substrate 100, the substrate 100 to which the semiconductor chips 1 are bonded may not necessarily be a plate-like material, and any material having the power supply areas (51, 52) on the surface can be applied as the substrate 100.

### <Twelfth Implementation Example>

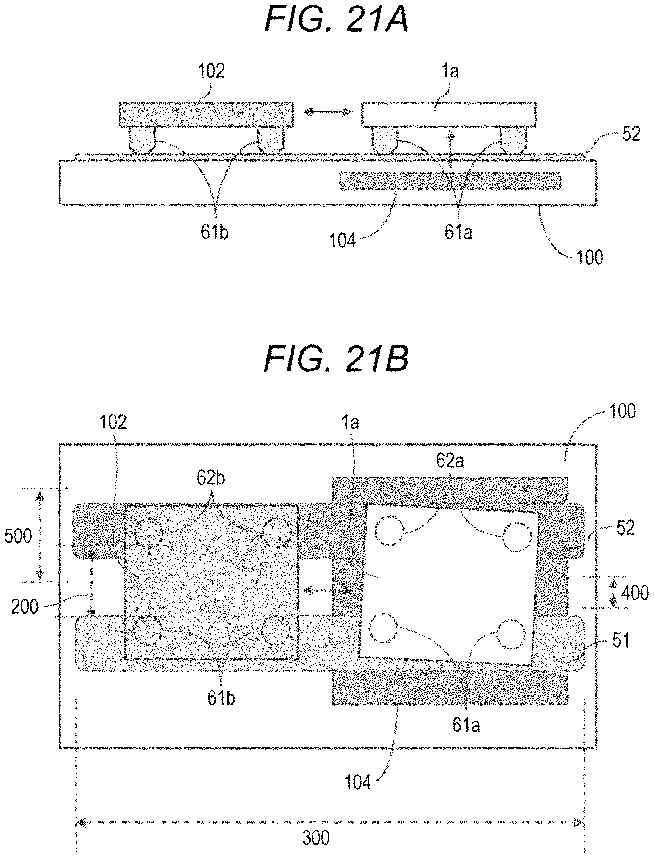

Fig. 21 includes diagrams illustrating a twelfth implementation example in which the semiconductor chip according to the present embodiment is mounted on a material. Fig. 21a illustrates a side view, and Fig. 21b illustrates a plan view. As illustrated in the plan view of Fig. 21b, the power supply area (51) on the negative electrode side and the power supply area (52) on the positive electrode side are provided on one side of the material 100, that is, the substrate 100. Furthermore, a semiconductor chip 102 having a power supply element and the semiconductor chip 1a are disposed on one side of the material 100, the power supply terminals (61) on the negative electrode side of the semiconductor chips are bonded to the power supply area (51) on the negative electrode side, and the power supply terminals (62) on the positive electrode side of the semiconductor chips are bonded to the power supply area (52) on the positive electrode side. Here, unlike the implementation examples described above, in the twelfth implementation example illustrated in Fig. 21, an external communication unit 104 that performs communication with external devices is mounted on the material side. The external communication unit 104 mounted on the material can communicate with the coil 70a of the semiconductor chip 1a by having a communication coil and a transmission/reception circuit provided thereto, and can also perform wireless communication with external devices outside the semiconductor module. With such a mounting structure, it is possible to supply power to all semiconductor chips in the semiconductor module and transmit/receive signals between all semiconductor chips in the semiconductor module and external devices.

### <Thirteenth Implementation Example>

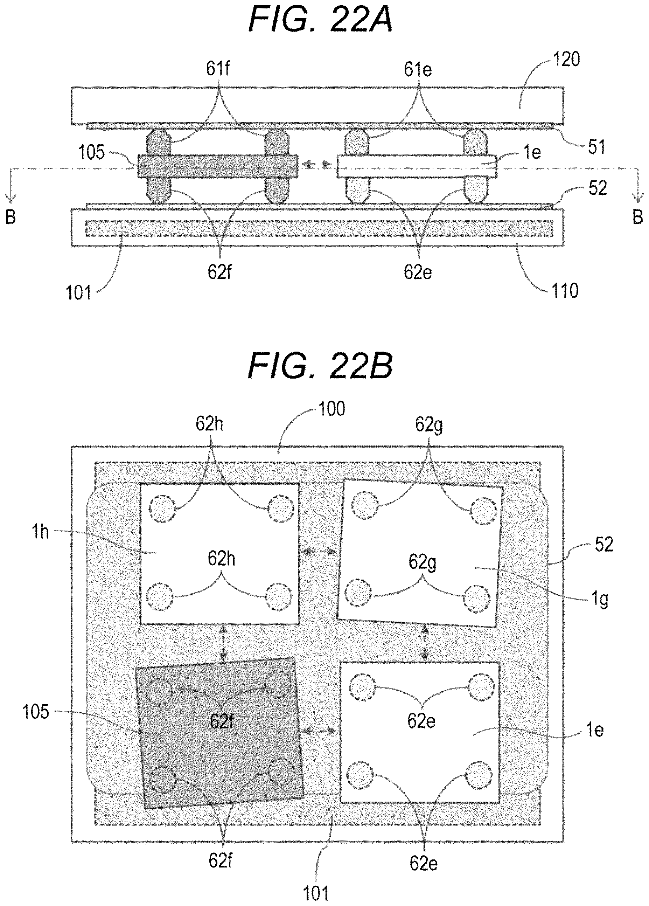

Fig. 22 includes diagrams illustrating a thirteenth implementation example in which the semiconductor chip according to the present embodiment is mounted on a substrate. Fig. 22a illustrates a side view, and Fig. 22b illustrates a sectional view taken along B-B line. As illustrated in Fig. 22, semiconductor chips (1e, 105, 1g, 1h) are provided at positions sandwiched by materials 110 and 120 from both top and bottom sides. The power supply area (52) on the positive electrode side is provided on the top face (face on the semiconductor chip side) of the material 110 on the lower side, and a power supply element 101 is further provided on the material 110 on the lower side. On the other hand, the power supply area (51) on the negative electrode side is provided on the bottom face (face on the semiconductor chip side) of the material 120 on the upper side. Furthermore, each of the semiconductor chips (1e, 105, 1g, 1h) disposed between the material 110 and the material 120 includes the power supply terminal (61) on the negative electrode side on the upper side and the power supply terminal (62) on the positive electrode side on the lower side. Moreover, at least one of the semiconductor chips disposed between the material 110 and the material 120 is configured to be the semiconductor chip 105 having an external communication function that enables communication with external devices. With such a mounting structure, it is possible to supply power to all semiconductor chips in the semiconductor module and transmit/receive signals between all semiconductor chips in the semiconductor module and external devices.

The semiconductor chips (1e, 105, 1g, 1h) can receive power supplied from each of the materials by being sandwiched between the two materials 110 and 120 in a state where the power supply terminals (61) on the negative electrode side are in contact with the power supply area (51) of the material 120 and the power supply terminals (62) on the positive electrode side are in contact with the power supply area (52) of the material 110. Furthermore, since the power supply area (51) on the negative electrode side is provided on the material 120 and the power supply area (52) on the positive electrode side is provided on the material 110, it is not necessary to provide two power supply areas of the positive electrode and negative electrode on the surface of a single material and not necessary to provide a space between the power supply areas. Thus, it is possible to provide the power supply areas almost on the whole face of the materials. Therefore, the power supply terminals and the power supply areas come in contact no matter where the semiconductor chips are disposed on the materials, so that it is not necessary to dispose the semiconductor chips at prescribed positions with high precision at the time of manufacturing.

Furthermore, when the materials 110 and 120 are formed with a soft material, the contact positions of the power supply areas of the materials and the power supply terminals of the semiconductor chips may be shifted due to the curved deformation of the materials. However, even in such a case, the semiconductor chips can remain in contact with the power supply areas and continue to acquire the power supply, since the power supply areas are widely formed on the face of the materials.

### <Fourteenth Implementation Example>

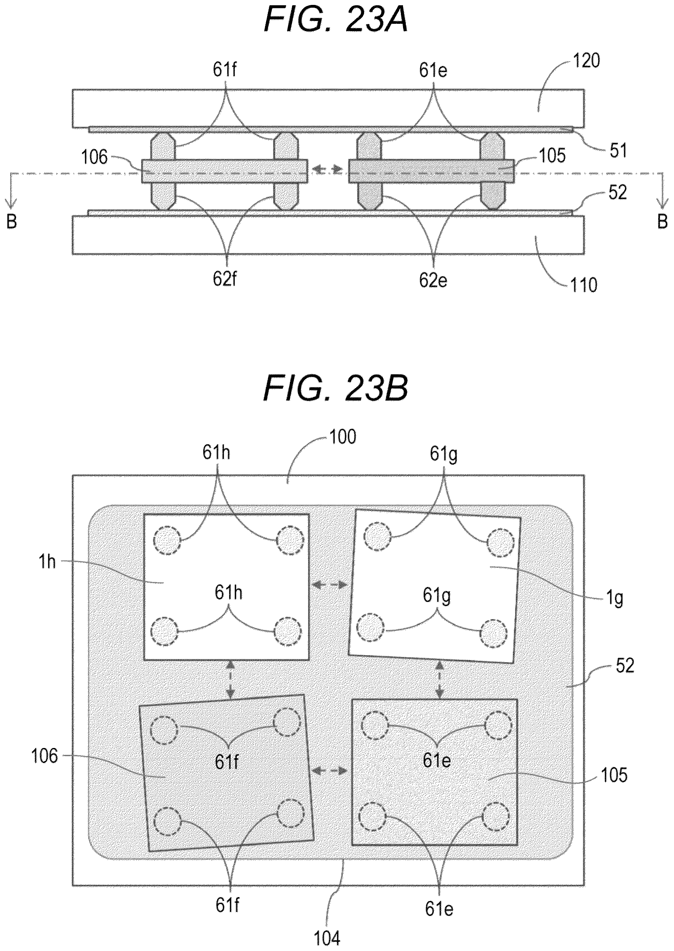

Fig. 23 includes diagrams illustrating a fourteenth implementation example in which the semiconductor chip according to the present embodiment is mounted on a material. Fig. 23a illustrates a side view, and Fig. 23b illustrates a sectional view taken along B-B line. As illustrated in Fig. 23, semiconductor chips (105, 106, 1g, 1h) are provided at positions sandwiched by the materials 110 and 120 from both top and bottom sides. The power supply area (52) on the positive electrode side is provided on the top face (face on the semiconductor chip side) of the material 110 on the lower side. On the other hand, the power supply area (51) on the negative electrode side is provided on the bottom face (face on the semiconductor chip side) of the material 120 on the upper side. Furthermore, each of the semiconductor chips (105, 106, 1g, 1h) disposed between the material 110 and the material 120 includes the power supply terminal (61) on the negative electrode side on the upper side and the power supply terminal (62) on the positive electrode side on the lower side. Moreover, at least any of the semiconductor chips disposed between the material 110 and the material 120 is configured to be the semiconductor chip 105 having an external communication function that enables communication with external devices and the semiconductor chip 106 having a power supply element. With such a mounting structure, it is possible to supply power of the power supply element loaded on the semiconductor chip 106 to all semiconductor chips via the material and transmit/receive signals between all semiconductor chips in the semiconductor module and external devices.

### <Fifteenth Implementation Example>

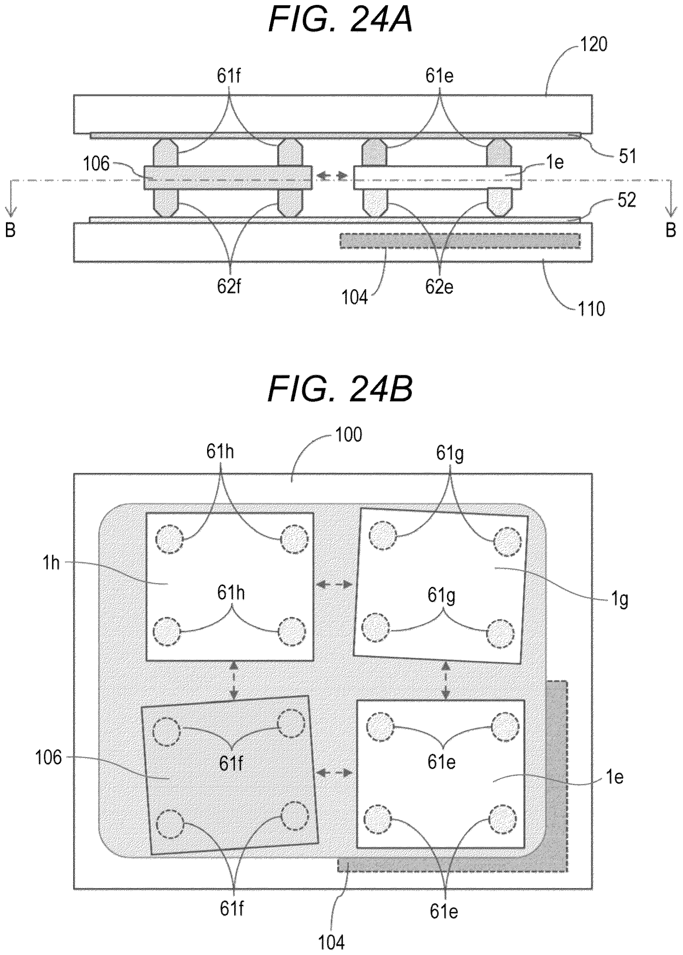

Fig. 24 includes diagrams illustrating a fifteenth implementation example in which the semiconductor chip according to the present embodiment is mounted on a material. Fig. 24a illustrates a side view, and Fig. 24b illustrates a sectional view taken along B-B line. As illustrated in Fig. 24, semiconductor chips (1e, 106, 1g, 1h) are provided at positions sandwiched by the materials 110 and 120 from both top and bottom sides. The power supply area (52) on the positive electrode side is provided on the top face (face on the semiconductor chip side) of the material 110 on the lower side. On the other hand, the power supply area (51) on the negative electrode side is provided on the bottom face (face on the semiconductor chip side) of the material 120 on the upper side. Furthermore, each of the semiconductor chips (1e, 106, 1g, 1h) disposed between the material 110 and the material 120 includes the power supply terminal (61) on the negative electrode side on the upper side and the power supply terminal (62) on the positive electrode side on the lower side. Furthermore, the external communication unit 104 that communicates with external devices is mounted on the material 110. The external communication unit 104 mounted on the material 110 can communicate with the coil 70a of the semiconductor chip 1e by having a communication coil and a transmission/reception circuit provided thereto, and can also perform wireless communication with external devices outside the semiconductor module. Moreover, at least one of the semiconductor chips disposed between the material 110 and the material 120 is configured to be the semiconductor chip 106 having a power supply element. With such a mounting structure, it is possible to supply power of the power supply element loaded on the semiconductor chip 106 to all semiconductor chips via the material and transmit/receive signals between all semiconductor chips in the semiconductor module and external devices.

### <Sixteenth Implementation Example>

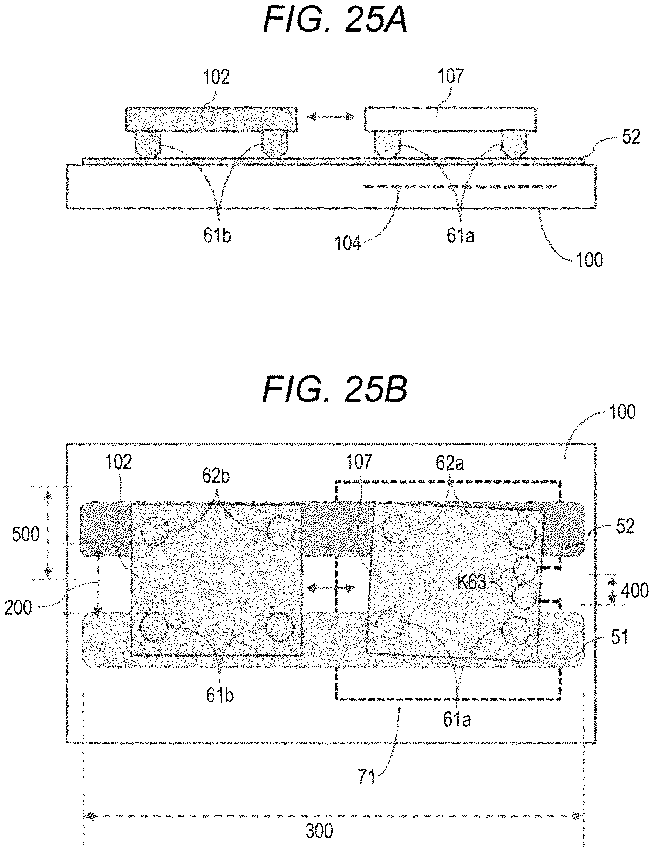

Fig. 25 includes diagrams illustrating a sixteenth implementation example in which the semiconductor chip according to the present embodiment is mounted on a material. Fig. 25a illustrates a side view, and Fig. 25b illustrates a plan view. As illustrated in the plan view of Fig. 25b, the power supply area (51) on the negative electrode side and the power supply area (52) on the positive electrode side are provided on one side of the material 100. Furthermore, a semiconductor chip 102 having a power supply element and a semiconductor chip 107 having an external communication function are disposed on one side of the material 100, the power supply terminals (61) on the negative electrode side of the semiconductor chips (102, 107) are bonded to the power supply area (51) on the negative electrode side, and the power supply terminals (62) on the positive electrode side of the semiconductor chips (102, 107) are bonded to the power supply area (52) on the positive electrode side. Here, unlike the twelfth modification example illustrated in Fig. 21, in the sixteenth implementation example illustrated in Fig. 25, a coil 71 for implementing the function of a communication antenna for communicating with external devices and an external transmission/reception circuit connected to the coil 71 are mounted separately on the material 100 and the semiconductor chip 107, respectively. More precisely, the coil 71 is mounted on the material 100, an external transmission/reception circuit and coil connection terminals K63 connected to the external transmission/reception circuit are mounted on the semiconductor chip 107, and the semiconductor chip 107 is disposed on the material 100 such that the coil connection terminals K63 abut against the coil 71. Furthermore, the semiconductor chip 107 is configured to include the coil 70 and the transmission/reception circuit 80 mounted on the semiconductor chip 1 in order to perform wireless communication with the other adjacent semiconductor chip. The semiconductor chip 107 is electrically connected to the coil 71 via the coil connection terminals K63. With such a mounting structure, it is possible to supply power to all semiconductor chips in the semiconductor module and transmit/receive signals between all semiconductor chips in the semiconductor module and external devices.

### <Seventeenth Implementation Example>

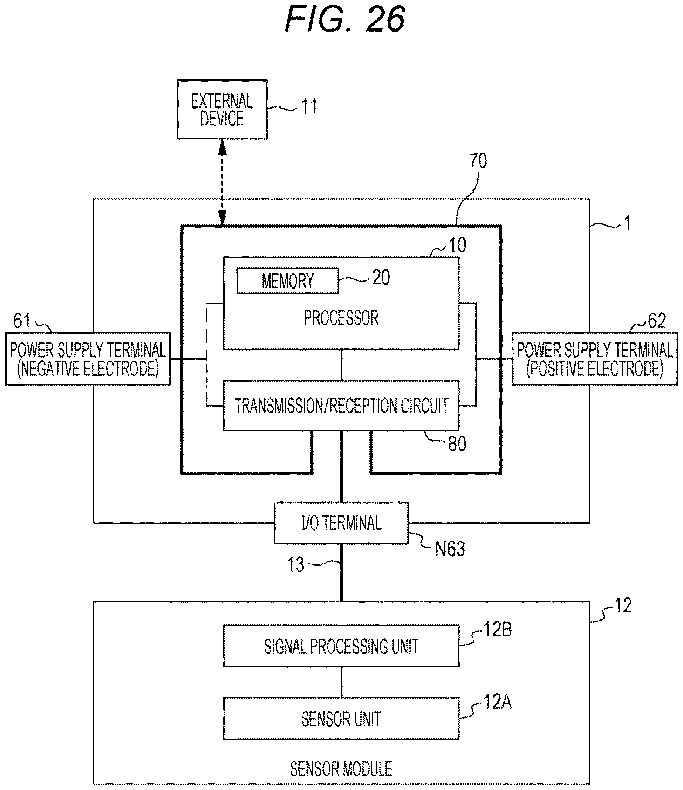

Hereinafter, a seventeenth implementation example according to the present invention will be described. Fig. 26 is a diagram illustrating a configuration example of the semiconductor chip 1 according to the seventeenth implementation example. In the seventeenth implementation example, in addition to the power supply terminals 61 and 62, the semiconductor chip 1 includes an input/output terminal N63 that connects to an external sensor module 12. The semiconductor chip 1 communicates with the sensor module 12 by wired communication through a wire 13, while communicating with an external device 11 (may be another semiconductor chip 1) other than the sensor module 12 by wireless communication via the coil 70. The semiconductor chip 1 exchanges text information, numerical information, image information, audio information, control information, and monitoring information, for example, through the wired communication and wireless communication described above.

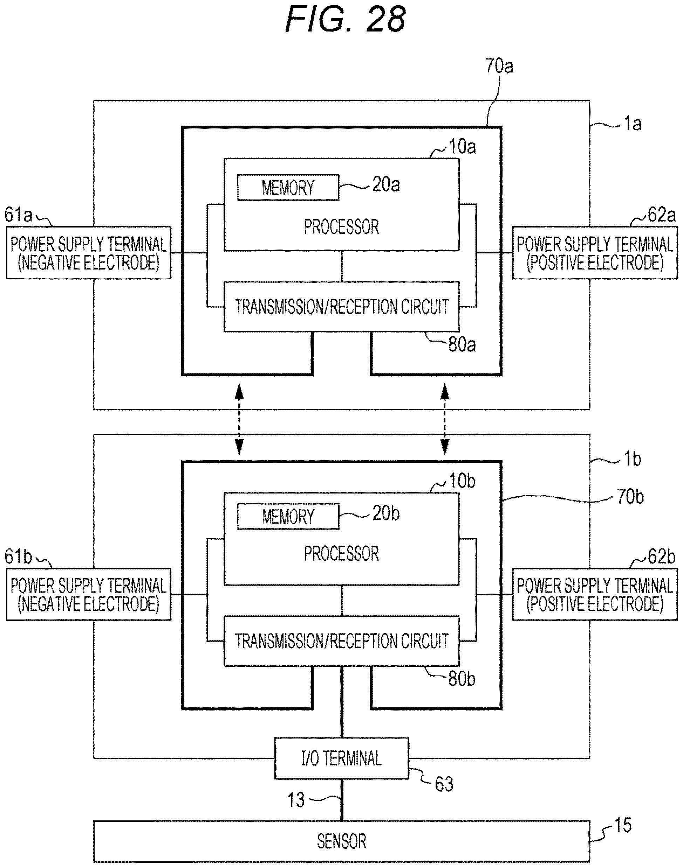

The sensor module 12 includes a sensor unit 12A and a signal processing unit 12B. The sensor unit 12A is, for example, a temperature sensor, a humidity sensor, a distance sensor, an optical sensor, or a magnetic sensor. The sensor unit 12A corresponds to a sensor device 15 described later with reference to Fig. 28, for example. The signal processing unit 12B includes, for example, an A/D conversion circuit (not illustrated) and a logic circuit (not illustrated). In the sensor module 12, the sensor unit 12A detects physical quantities such as temperature and humidity and outputs the detected physical quantities to the signal processing unit 12B. In the signal processing unit 12B, the A/D conversion circuit converts the physical quantities from analog signals to digital signals, and the logic circuit processes the digital signals, more specifically, processes the digital signals to comply with the protocols of wired communication using the wire 13. The wire 13 between the sensor module 12 and the semiconductor chip 1 may be, for example, a configuration with only one data signal line for serial communication, may be a configuration with a single clock signal line for communicating clock signals and a single data signal line for performing bi-directional serial communication (I2C bus), or may be a configuration with a single clock signal line and two unidirectional (for transmission and reception) data signal lines (SPI bus). In this case, the input/output terminal N63 may be provided by corresponding to the number of signal lines.

This allows output data from the sensor module 12 that outputs digital signals by wire to be propagated to the outside via near-field wireless communication using inductive coupling.

Instead of the sensor module 12, it is possible to employ various functional modules (for example, an imaging module, a display module, a microphone module, a speaker module, or a clock module), and connect the functional modules to the input/output terminal N63. In this case, the semiconductor chip 1 communicates with the functional module by wire and communicates with the external device 11 other than the functional modules wirelessly via the coil 70.

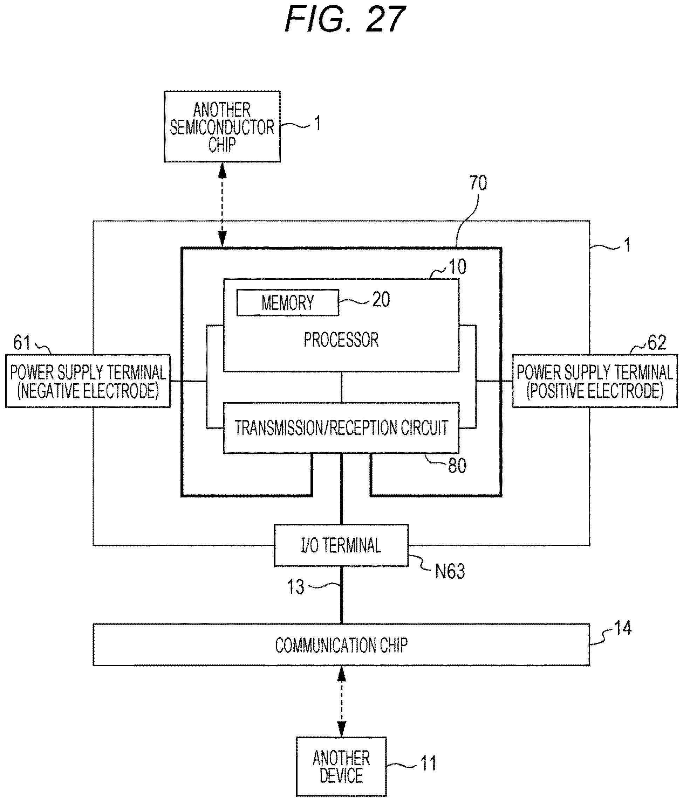

Furthermore, instead of the sensor module 12, it is possible to employ a communication chip 14. Fig. 27 is a diagram illustrating a configuration example of a case where the communication chip 14 is employed. In this case, the semiconductor chip 1 can perform near-field wireless communication with the other semiconductor chip 1 by inductive coupling via the coil 70, and perform wired communication using the wire 13 as well as wireless communication via the communication chip 14 with the other device 11 than the semiconductor chip 1. Wired communication using the wire 13 can employ, for example, the I2C bus and the SPI bus described above, while wireless communication with the other device 11 via the communication chip 14 can be performed according to protocols such as Wi-Fi, Bluetooth (registered trademark), LTE, and LPWA, for example, and the communication chip 14 can perform communication control according to those protocols.

Instead of the sensor module 12, an analog sensor device 15 may be employed as well. Fig. 28 is a diagram for describing a semiconductor module that includes the semiconductor chip 1a described in the first implementation example, and the semiconductor chip 1b according to the seventeenth implementation example. In the seventeenth implementation example, the semiconductor chip 1b performs primary processing, while the semiconductor chip 1a performs secondary processing. As illustrated in the same diagram, analog signals from the analog sensor device 15 are transmitted to the semiconductor chip 1b via wired communication using the wire 13, and the semiconductor chip 1b can perform primary processing on the analog signals from the sensor device 15. The primary processing is similar to the processing of the signal processing unit 12B described above by referring to Fig. 26. More precisely, for example, it is the processing for converting the physical quantities detected by the sensor device 15 from analog signals to digital signals and generating the signals suitable for wireless communication between the semiconductor chip 1a and the semiconductor chip 1b from the digital signals. The semiconductor chip 1b can transmit the primary-processed data to the semiconductor chip 1a via wireless communication by inductive coupling via the coil 70b. The semiconductor chip 1a can perform secondary processing using the primary-processed data. The secondary processing may be aggregation processing, analysis processing, or the like, for example.

### <Eighteenth Implementation Example>

### <Overview of System>

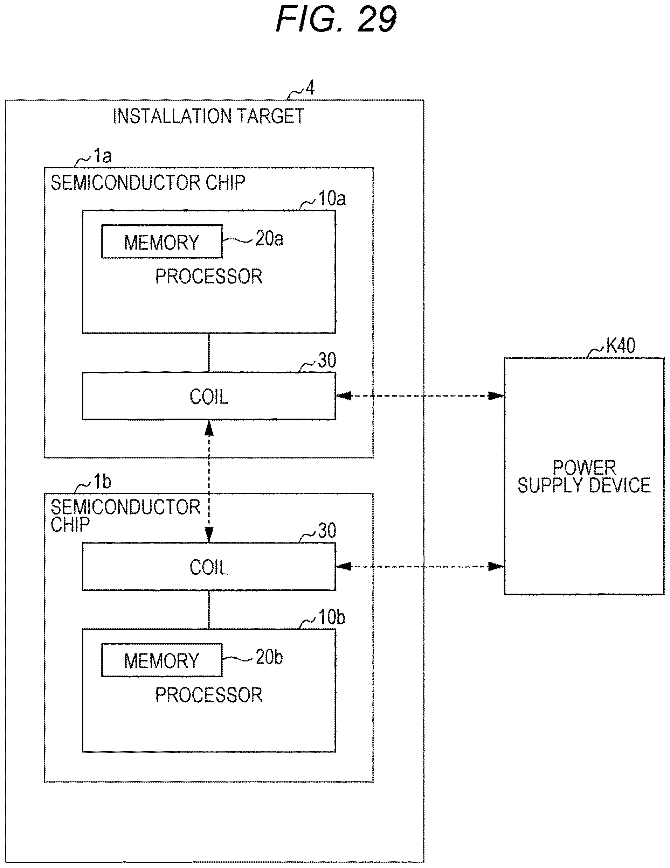

Fig. 29 is a diagram illustrating a configuration example of an information processing device according to the eighteenth implementation example of the present invention. The information processing device of the eighteenth implementation example is configured including a plurality of semiconductor chips (1a, 1b). The semiconductor chip 1 is a device that can measure the measurement values that change in accordance with the state of the semiconductor chip, such as the relative positional relationship with respect to the other semiconductor chip 1. The semiconductor chips 1 are disposed on the surface or inner side of an installation target 4 where semiconductor chips are installed, and the state of the installation target 4 (for example, operating state, deformation, temperature, vibration, pressure, electromagnetic waves, sound volume, and humidity) can be estimated by calculation through measuring the relative positional relationship with respect to the other semiconductor chip 1. The installation target 4 may be, for example, a device in which a plurality of objects relatively move or deform, such as a door and a motor, may be civil engineering and construction materials such as embankment material and concrete, or may also be water, air, and the like.

The semiconductor chip 1 includes the processor 10 and the coil 30, and the processor 10 includes the memory 20. A nonvolatile storage device is included in at least part of the memory 20, and programs and the like to be executed by the processor 10 can be stored therein. The coil 30 can function as a communication antenna when communicating with the other semiconductor chip, and can transmit and receive signals with the coil 30 of the other semiconductor chip 1 disposed adjacently by a near-field communication scheme via a near-field electromagnetic field, by communication using other inductive coupling, or by other communication schemes. The coil 30 can also function as a measurement unit to detect voltage values, voltage amplitudes, and the like of communication signals received from the other semiconductor chip. Furthermore, the coil 30 can also function as a power reception unit to which power is supplied from a power supply device K40 outside the semiconductor chip.

The power supply device K40 generates a current in a prescribed frequency band in the coil 30 of the semiconductor chip by generating an electromagnetic field using, for example, a magnetic field induction method, a magnetic field resonance method, or the like.

### <Hardware>

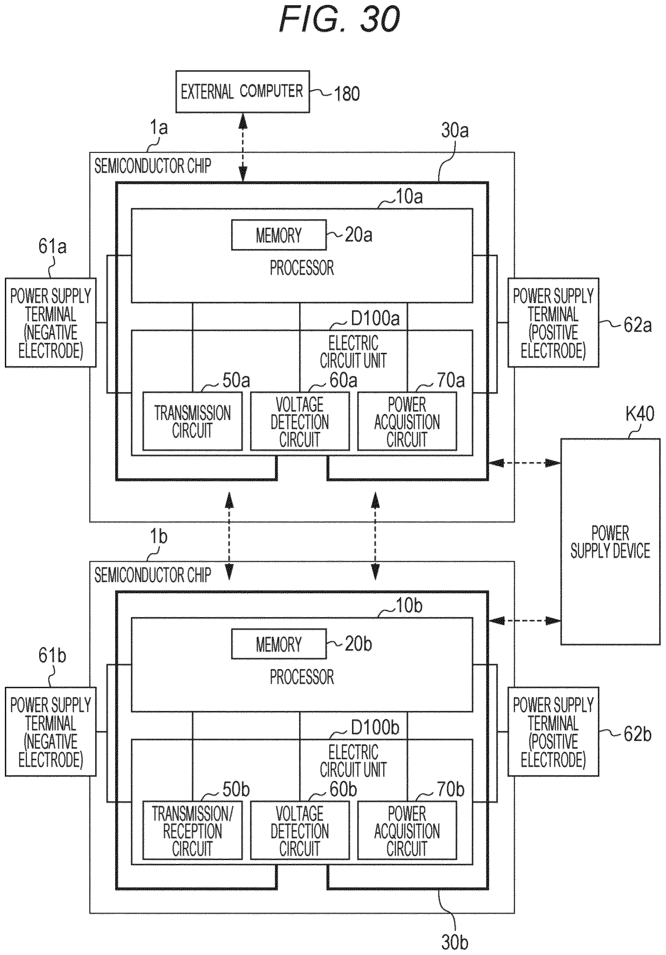

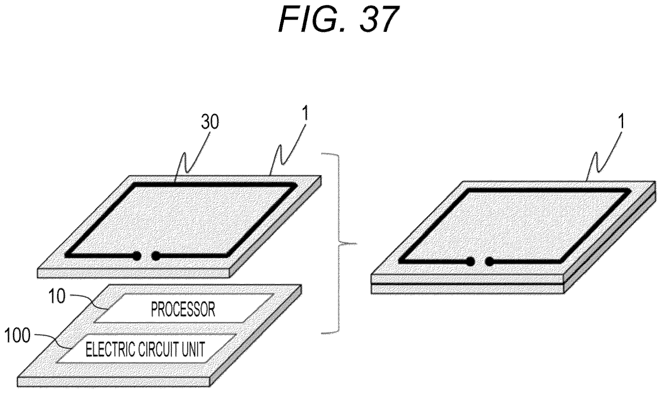

Fig. 30 illustrates an example of a hardware configuration as an example for implementing a semiconductor chip, in which the coil 30 is provided in the outer periphery of the processor and an electric circuit unit D100 in the semiconductor chip 1 and, further, the electric circuit unit D100 includes a transmission circuit 50, a voltage detection circuit 60, and a power acquisition circuit 70. The example illustrated in Fig. 30 indicates a case where the semiconductor chip 1a and the semiconductor chip 1b are used as a pair. The semiconductor chips 1 respectively include: processors (10a, 10b), memories (20a, 20b) provided in the processors, coils (30a, 30b) configured with a wire and the like provided in the outer periphery of the semiconductor chips; transmission circuits (50a, 50b) connected to the processors 10 in a communicable manner, and generate voltage signals to be transmitted to the coils (30a, 30b); voltage detection circuits (60a, 60b) that detect the voltage of the coils (30a, 30b), and power acquisition circuits (70a, 70b) that acquire power flowing in the coils (30a, 30b). While Fig. 30 illustrates a case where the coil is configured with a single wire, the coil may be configured with a plurality of wires. Furthermore, while the example illustrated in Fig. 30 indicates the case where the processor and the electric circuit unit D100 are provided on the inner side of the area where the coil 30 is formed and the coil 30 is provided to surround the outer side of the processor and the electric circuit unit D100, the position of the coil is not limited thereto. As another example, it is possible to provide one of or both of the processor and the electric circuit unit D100 not on the inner side of the area covered by the coil but on the outer side of the coil. Alternatively, as illustrated in Fig. 37, in a case where the structure of the semiconductor chip is a layered structure with a plurality of layers, the coil 30 may be provided in a different layer from the layer of at least one of the processor 10 and the electric circuit unit D100. The semiconductor chip illustrated in Fig. 37 may be configured with a single chip having an upper layer and a lower layer, or may be configured as separate semiconductor chips with the upper layer and the lower layer being electrically connected.

At least one of the semiconductor chips 1 (the semiconductor chip 1a in Fig. 30) is connected to an external computer 180 in a communicable manner. Communication between the external computer 180 and the semiconductor chip 1 is executed based on a communication request signal from either the external computer 80 or the semiconductor chip 1 or from both, which can be performed by wireless communication via the coil 30.

The external computer 180 is a computer that receives at least one of communication history information, measurement value information, state quantity information, measurement logic information, and other semiconductor chip information stored in each storage unit of the semiconductor chip 1a, and performs, for example, statistical processing or the like based on the received information regarding a plurality of semiconductor chips.

The transmission circuit 50 is a circuit electrically connected to the coil 30, and generates a communication signal to be transmitted to the coil 30 based on a command for generating a communication signal generated by the processor. Specifically, a voltage signal configuring a communication signal is generated in the coil 30.

The voltage detection circuit 60 is a circuit electrically connected to the coil 30, and detects the voltage value generated in the coil 30. A wireless communication signal from the other semiconductor chip or the external computer 180 is received by the coil 30, and the wireless communication signal is generated in the coil 30 as the voltage signal. The signal intensity (voltage value or voltage amplitude) of the wireless signal changes in accordance with the relative positional relationship with the other semiconductor chip or the external computer 180 as the communicating destination. The processor can recognize the received wireless signal by detecting the voltage value generated in the coil 30 by the voltage detection circuit 60. Furthermore, by performing calculation processing of the voltage value or voltage amplitude generated in the coil 30 using a prescribed calculation logic, the processor can estimate, by calculation, the state quantity of the semiconductor chip including the relative positional relationship and the like between the own semiconductor chip 1 and the other semiconductor chip 1, and the state (for example, operating state of the installation target, deformation, temperature, vibration, pressure, electromagnetic wave, sound volume, and humidity) of the installation target 4 where the semiconductor chips are installed.

The power acquisition circuit 60 is a circuit electrically connected to the coil 30, and acquires power from the current generated in the coil 30 due to the electromagnetic field generated by the power supply device K40 outside the semiconductor chip. The power acquired by the power acquisition circuit 60 is supplied to the processor 10, the memory 20, and the like, and it is used as the power required to drive each structural component of the semiconductor chip.

As described above, the electric circuit unit D100 has the transmission circuit 50, the voltage detection circuit 60, and the power acquisition circuit 70 independent from each other, so that each of the functions of transmitting/receiving wireless signals, acquiring measurement values, and acquiring power can be implemented by using a common coil.

By mounting the processor and the electric circuit unit illustrated in Fig. 30 on the semiconductor chip in an inseparable manner, the semiconductor chip of the eighteenth implementation example can be configured with a CPU. For example, the processor and the electric circuit unit can be mounted on the semiconductor chip (on a single chip) in an inseparable manner. Note here that a semiconductor chip is defined as a small thin piece of silicon (silicon die or die) on which electronic circuits are assembled. Alternatively, in some cases, it can also be defined as a package in which the silicon die is encapsulated.

### <Software>

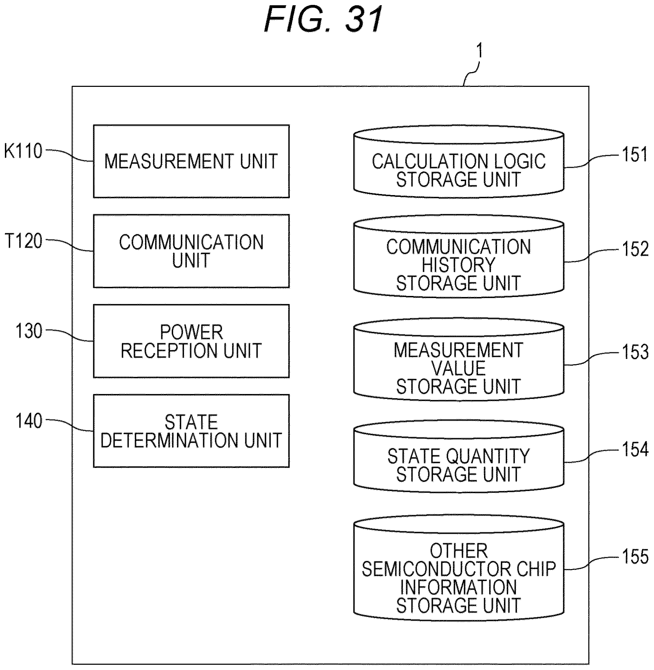

Fig. 31 is a block diagram illustrating the functional configuration of the semiconductor chip 1. The semiconductor chip 1 includes a measurement unit K110, a communication unit T120, a power reception unit 130, a state determination unit 140, a measurement logic recording unit 151, a communication history storage unit 152, a measurement value storage unit 153, a state quantity storage unit 154, and another semiconductor chip information storage unit 155. The measurement unit K110 can be implemented by recording, by the processor, the voltage values of the coil 30 detected by the voltage detection circuit 60 in the memory. Furthermore, the communication unit T120 can be implemented by generating, by the processor, the communication signal in the coil via the transmission circuit 50, and recognizing the communication signal from the voltage value of the coil 30 detected by the voltage detection circuit 60. Furthermore, the power reception unit 130 can be implemented by acquiring, by the power acquisition circuit 70, power from the current generated in the coil. Moreover, the state determination unit can be implemented by calculating, using the calculation logic recorded in advance, the state quantity from the voltage value (measurement value) of the coil 30 detected by the voltage detection circuit 60. The measurement logic recording unit 151, the communication history storage unit 152, the measurement value storage unit 153, the state quantity storage unit 154, and the other semiconductor chip information storage unit 155 can be implemented as part of the storage area of the memory 20 provided in the semiconductor chip.

The calculation logic storage unit 151 stores the calculation logics. In the calculation logic storage unit 151 of the present implementation example, the calculation logics are stored by being linked to the kinds of the state quantities of the semiconductor chip or of the state quantities of the installation target 4. The calculation logic includes an algorithm for calculating the state quantity based on the measurement value.

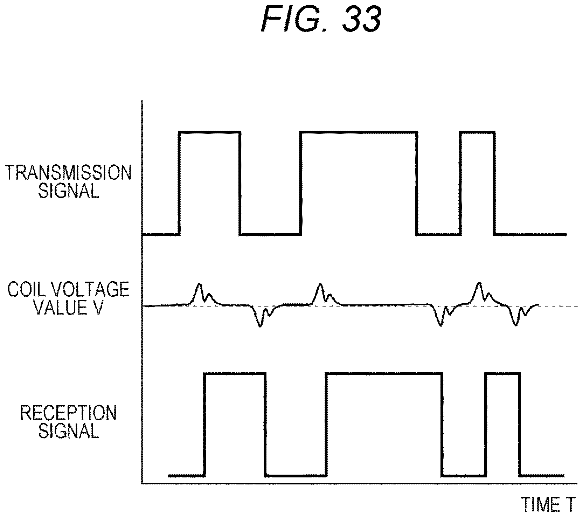

The measurement unit K110 measures the measurement value that can be measured by the coil 30, and records the measurement value in the measurement value storage unit. Here, the measurement value is a value measured by the coil 30, which in the present implementation example can be defined as the voltage value generated in the coil. Fig. 33 indicates the voltage values generated in the coil 30 by the transmission signals transmitted from a nearby semiconductor chip, and the reception signals generated based on the voltage values. The voltage value or the voltage amplitude of the coil indicated in Fig. 33 changes according to the positional relationship between the two semiconductor chips. Thus, the measurement unit K110 can acquire the voltage value or the voltage amplitude of the coil as the measurement value. Furthermore, the measurement values measured by the measurement unit K110 are recorded in the measurement value storage unit 153.

The state determination unit 140 calculates, using the calculation logic recorded in advance, the state quantity from the voltage value (measurement value) of the coil 30 detected by the voltage detection circuit 60. Note here that the state quantity is the value related to the state of the semiconductor chip or the state of the installation target 4, and can be, for example, the relative distance or relative angle of a plurality of semiconductor chips, or the temperature, vibration, pressure, electromagnetic wave, sound volume, humidity, or the like of the installation target 4. For example, when the positional relationship between two semiconductor chips changes, the voltage or amplitude of the voltage generated in the coils changes. Furthermore, the change in the positional relationship between two semiconductor chips is affected by the temperature, pressure, humidity, sound, electromagnetic wave, and the like of the installation target in which the semiconductor chips are embedded, disposed, or affixed. The state determination unit 140 can estimate the various state quantities described above by processing the changes in the voltage or the voltage amplitude of the coils caused by changes in the relative position or relative angle of the semiconductor chips using the calculation logics stored in the calculation logic storage unit. The estimated state quantities are recorded in the state quantity storage unit 154.

Fig. 33 indicates the voltage values generated in the coil 30 by the transmission signals transmitted from a nearby semiconductor chip, and the reception signals generated based on the voltage values. Since the voltage value or the voltage amplitude of the coil indicated in Fig. 33 changes according to the positional relationship between the two semiconductor chips, the various state quantities described above can be estimated based on the voltage amplitude.

When transmitting a signal, the communication unit T120 transmits a wireless signal to the other semiconductor chip or the external computer by generating, by the processor, a communication signal in the coil via the transmission circuit 50. Furthermore, when receiving a signal, the processor performs reception processing of the wireless signal by recognizing the communication signal based on the voltage value of the coil 30 detected by the voltage detection circuit 60. Furthermore, the communication history information transmitted or received by the communication unit T120 is recorded in the communication history storage unit 152. Here, as indicated in Fig. 33, for example, a reception signal can be generated by performing processing such that a pulse signal of a reception signal rises due to a voltage rise on the plus side in the voltage value of the coil and the pulse signal of the reception signal returns to zero due to a voltage fall on the minus side in the voltage value of the coil. Furthermore, the information of the other semiconductor chip acquired as the reception signal by the communication unit T120 is recorded in the other semiconductor chip information storage unit 155.

The power reception unit 130 acquires, by the power acquisition circuit 70, power from the current generated in the coil 30 to acquire the power used by the structural components in the semiconductor chip, such as the processor. The power supply device K40 generates a current in a prescribed frequency band in the coil 30 of the semiconductor chip by generating an electromagnetic field using a magnetic field induction method, a magnetic field resonance method, or the like. Therefore, the power acquisition circuit 70 is configured to be able to acquire the power from the current in the prescribed frequency band.

Note here that, in a case where at least one of the communication unit T120 and the measurement unit K110 utilizes the phenomenon that the voltage is generated in the coil via the electromagnetic fields, it is difficult to achieve three functions of communicating, measuring, and supplying power using the common coil due to interference of the electromagnetic fields when trying to receive power supplied by a power supply method utilizing the electromagnetic fields via the common coil. However, when the communication unit T120 uses near-field communication using the near field generated with the other semiconductor chip, the wireless signal is not modulated and is generated in a wide frequency band from zero to the gigahertz bands. Thus, by employing, as a power supply method, a magnetic field induction method or a magnetic field resonance method which modulates the wireless signal to a specific frequency (for example, several tens of megahertz band), it is possible to implement the three functions of communicating, measuring, and supplying power by using the common coil without causing almost no influence of the electromagnetic field in the frequency band used for supplying power imposed upon the electromagnetic field of the near-field communication.

### <Operations>

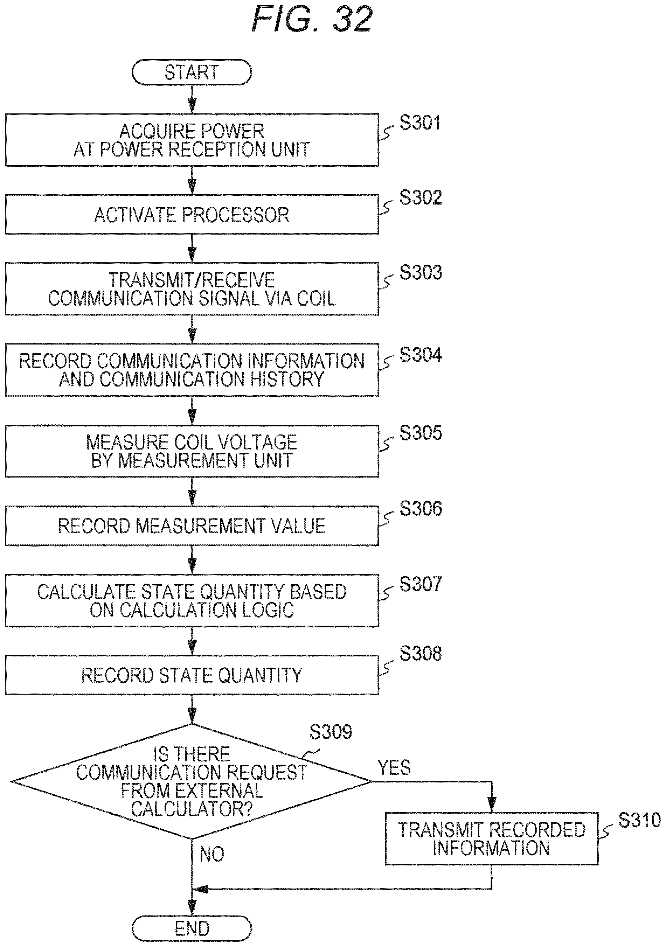

Fig. 32 is a control flowchart for describing a flow of the processing of the information processing device as the eighteenth implementation example of the present invention.

The information processing device including a plurality of semiconductor chips first acquires power at the power reception unit 130 (S301). Then, the processor is activated by the received power (S302). Next, communication signals are transmitted or received via the coil 30 by the communication unit T120 (S303). Thereafter, communication information regarding the contents of the communication signals and information on the communication history are stored in the communication history storage unit 152 (S304). Then, the measurement unit measures the voltage value or amplitude of the voltage generated in the coil (S305). Next, the measurement value is recorded in the measurement value storage unit 153 (S306). Thereafter, the state quantity is calculated by the state determination unit based on the calculation logic recorded in the calculation logic storage unit 151 (S307). Then, the calculated state quantity is stored in the state quantity storage unit 154 (S308). Next, whether there is a communication request from the external computer is determined (S309) and, when there is no communication request, the processing is ended. When there is a communication request from the external computer, the information recorded in each of the storage units (the calculation logic storage unit, the communication history storage unit, the measurement value storage unit, the state quantity storage unit, and the other semiconductor chip information storage unit) in the semiconductor chip is transmitted to the external computer (S310), and the processing is ended.

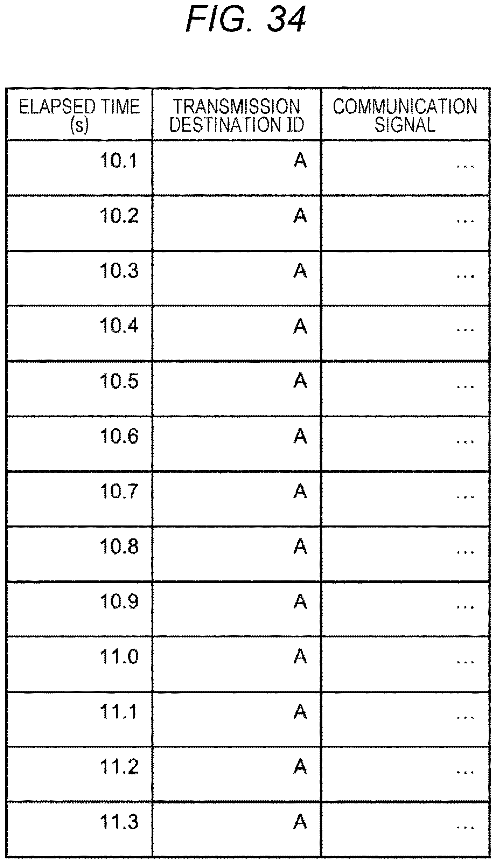

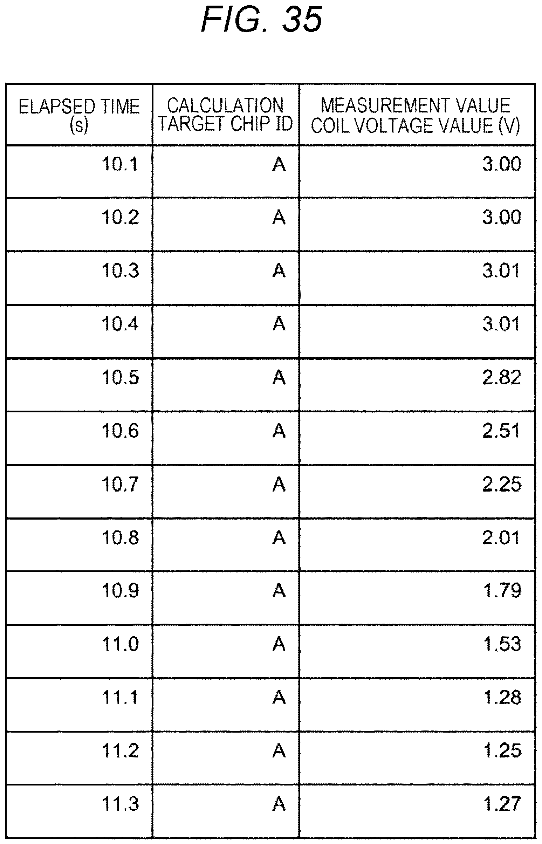

Fig. 34 is a table illustrating an example of the information stored in the communication history storage unit. In the communication history storage unit 152, the time at which communication information is acquired (elapsed time from the start of measurement), ID information of the semiconductor chip or external computer as the communication destination, and information regarding the contents of the communication signal are recorded. In the example illustrated in Fig. 35, the communication signal with a semiconductor chip A that is the measurement target is measured at 0.1 second intervals. Furthermore, ID information of the semiconductor chip or the external calculator as the communication destination is included in the communication signal.

Fig. 35 is a table illustrating an example of the information stored in the measurement value storage unit. In the measurement value storage unit 153, the measurement time at which the measurement value is measured (elapsed time from the start of measurement), the identification information of the semiconductor chip as the measurement target, and the measurement value (the voltage value generated in the coil in the example illustrated in Fig. 35) are recorded. In the example illustrated in Fig. 35, the communication signal with a semiconductor chip A that is the measurement target is measured at 0.1 second intervals. The voltage value generated in the coil is 3.00 V at an elapsed time of 10.1 seconds, which gradually decreases to 1.27 V at 11.3 seconds.

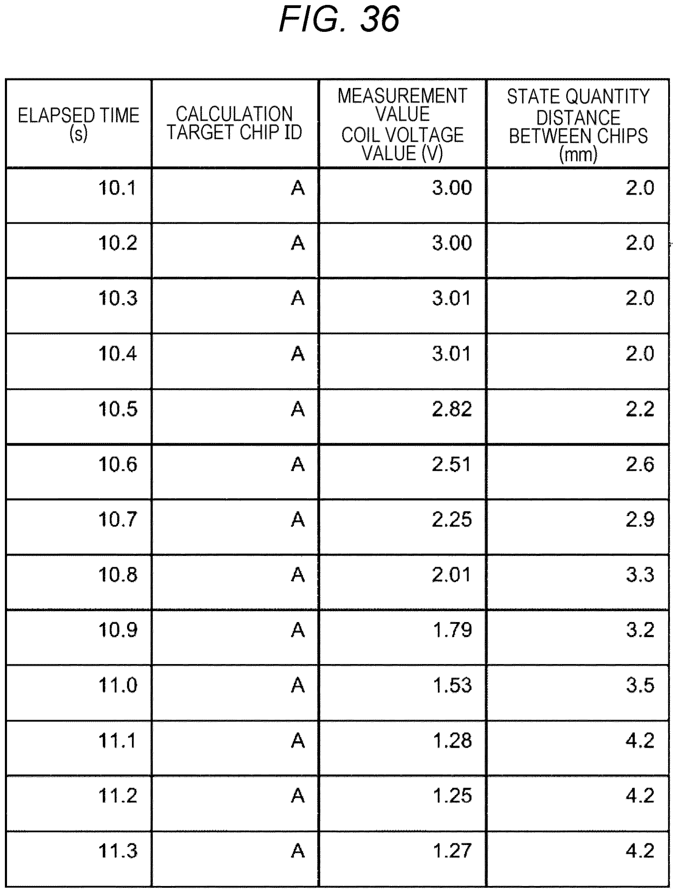

Fig. 36 is a table illustrating an example of the information stored in the state quantity storage unit. In the state quantity storage unit 154, each of the measurement time at which the measurement value is measured (elapsed time from the start of measurement), the identification information of the semiconductor chip as the measurement target, the measurement value (the voltage value generated in the coil in the example illustrated in Fig. 36), and the state quantity calculated from the measurement value (distance between the semiconductor chips in the example illustrated in Fig. 36) is recorded. In the example illustrated in Fig. 36, the distance between the semiconductor chips estimated based on the voltage value generated in the coil is 2.0 mm at an elapsed time of 10.1 seconds, which gradually increases to 4.2 mm at 11.3 seconds.

### <Modification Examples of First to Eighteenth Implementation Examples>

In the semiconductor chips of the implementation examples described above, the processor may be provided inside the coil.

In the semiconductor module of the implementation examples described above, the positive electrode power supply terminal (62a) of the first semiconductor chip (1a) and the positive electrode power supply terminal (62b) of the second semiconductor chip (1b) may be bonded or abutted against the same positive electrode power supply area (52), and the negative electrode power supply terminal (61a) of the first semiconductor chip (1a) and the negative electrode power supply terminal (61b) of the second semiconductor chip (1b) may be bonded or abutted against the same negative electrode power supply area (51). This point is illustrated in Figs. 6a and 6b, for example.

In the semiconductor module of the implementation examples described above, the width of the positive electrode power supply area (52) and the negative electrode power supply area (51) in the direction where the first semiconductor chip (1a) and the second semiconductor chip (1b) are disposed may be twice or more than the width of the semiconductor chips (1a, 1b). This point is illustrated in Figs. 6a and 6b, for example.

In addition to the semiconductor module of the implementation examples described above including the first semiconductor chip (1a), the second semiconductor chip (1b), and a sensor (for example, the sensor unit 12A illustrated in Fig. 26) connected to the first semiconductor chip (1a) by wire, in which: the processor (for example, the processor 10a illustrated in Fig. 2) provided in the first semiconductor chip (1a) performs processing on a signal received from the sensor (12A), and transmits processed data to the coil (for example, the coil 70b illustrated in Fig. 2) of the second semiconductor chip (1b) via the coil (for example, the coil 70a illustrated in Fig. 2) by induction coupling; and the processor (for example, the processor 10b illustrated in Fig. 2) provided in the second semiconductor chip (1b) performs processing based on the data received from the coil (70b) of the second semiconductor chip (1b), the semiconductor module may include third semiconductor chips (for example, semiconductor chips 1c, 1d, 1e, 1f) that include processors, coils for performing wireless communication, and the positive electrode power supply terminals (62) as well as the negative electrode power supply terminals (61) for acquiring the driving power of the processor from outside the semiconductor chips, in which: the positive electrode power supply terminals (62) of the third semiconductor chips (1c, 1d, 1e, 1f) may be bonded or abutted against the same positive electrode power supply area (52); and the negative electrode power supply terminals (61) of the third semiconductor chips may perform wireless communication by inductive coupling between the coils of the third semiconductor chips (1c, 1d, 1e, 1f) bonded or abutted against the same negative electrode power supply area (51) and the coil of the second semiconductor chip (1b). This point is illustrated in Fig. 15, for example.

In the semiconductor chip (1a) with the processor and the coil according to the implementation examples described above, which includes: a communication unit (80a) that performs communication with another semiconductor chip (1b) by using the coil (70a); the measurement unit (for example, the measurement unit K110 illustrated in Fig. 31) that acquires the measurement value in accordance with the state of the information processing device by using the coil (70a); and the power reception unit (for example, the power reception unit 130 illustrated in Fig. 31) that acquires power consumed in the semiconductor chip (1a) by using the coil (70a), the coil (70a) may transmit the power to a coil outside the semiconductor chip (1a). This point is illustrated in Fig. 28, for example.

In view of a combination with a structure where power is received via the coil, the semiconductor chip (1a) with the processor (10) and the coil (30) described above, which includes: the communication unit (for example, the communication unit 40 illustrated in Fig. 1) that performs communication with the other semiconductor chip (1b) by using the coil (30); the measurement unit (for example, the measurement unit K110 illustrated in Fig. 31) that acquires the measurement value in accordance with the state of the information processing device by using the coil (30); and the power reception unit (for example, the power reception unit 130 illustrated in Fig. 31) that acquires power consumed in the semiconductor chip (1a) by using the coil (30), may include the positive electrode power supply terminal (for example, the positive electrode power supply terminal 62 illustrated in Fig. 6) and the negative electrode power supply terminal (for example, the negative electrode power supply terminal 61 illustrated in Fig. 6) configured to acquire the driving power of the processor (10) from outside the semiconductor chip (1a). This point is illustrated in Fig. 29, for example.

The two coils described above communicate with each other by magnetic field coupling. Communication by magnetic field coupling is a transmission method that uses the principle of electromagnetic induction for transmission of information. Furthermore, communication by inductive coupling and communication by magnetic field resonance that uses the resonance phenomenon of the transmission/reception coils are also included in communication by magnetic field coupling.

While the present embodiment is described heretofore, the embodiment described above is intended to facilitate understanding of the present invention and is not intended to limit the present invention. The present invention may be changed and modified without departing from the spirit and scope thereof, and equivalents are also included in the present invention. The present embodiment may be used alone or may be used in combination.

### Industrial Applicability

The semiconductor module, semiconductor chip, and semiconductor module manufacturing method according to the present disclosure can be used to more easily manufacture semiconductor modules and semiconductor chips.

### Reference Signs List

- 1a: Semiconductor chip

- 1b: Another semiconductor chip
- 10a: Processor
- 51: Negative electrode power supply area
- 52: Positive electrode power supply area
- 61a: Negative electrode power supply terminal
- 62a: Positive electrode power supply terminal
- 70a: Coil

## Claims

1. A semiconductor chip comprising:
a processor;
a coil for performing wireless communication with another semiconductor chip;
a positive electrode power supply terminal; and
a negative electrode power supply terminal,
wherein:
in a material that includes a positive electrode power supply area and a negative electrode power supply area, the positive electrode power supply area is bonded or abutted against the positive electrode power supply terminal,
the negative electrode power supply area is bonded or abutted against the negative electrode power supply terminal, and
at least one of an area of the positive electrode power supply area and an area of the negative electrode power supply area is larger than an area of at least one of an end portion of the positive electrode power supply terminal and an end portion of the negative electrode power supply terminal.

2. The semiconductor chip according to claim 1, wherein:
the positive electrode power supply terminal and the negative electrode power supply terminal are disposed on a first surface on one side of the semiconductor chip, and
the semiconductor chip comprises a positive electrode area and a negative electrode area with exposed electrodes on a second surface opposite to the first surface.

3. The semiconductor chip according to claim 1, wherein:
terminals of the semiconductor chip consist of only the positive electrode power supply terminal and the negative electrode power supply terminal.

4. The semiconductor chip according to claim 1, wherein:
communication with the other semiconductor chip is not performed via the positive electrode power supply terminal and the negative electrode power supply terminal but is performed by wireless communication via the coil.

5. The semiconductor chip according to claim 1, wherein:
the processor is provided inside the coil.

6. The semiconductor module according to claim 1, further comprising:
a positive electrode conductive part that electrically connects the positive electrode power supply terminal and the positive electrode area; and
a negative electrode conductive part that electrically connects the negative electrode power supply terminal and the negative electrode area.

7. The semiconductor module according to claim 5, further comprising:
on a first surface on the material side, the first positive electrode power supply terminal and the first negative electrode power supply terminal,
wherein:
the semiconductor module comprises, on a second surface opposite to the first surface, a first positive electrode area where a positive electrode is exposed and a first negative electrode area where a negative electrode is exposed.

8. The semiconductor chip according to claim 5, wherein:
a distance between the positive electrode power supply area and the negative electrode power supply area provided on the material is shorter than a distance between the positive electrode power supply terminal and the negative electrode power supply terminal.

9. The semiconductor module according to claim 5, wherein:
the semiconductor chip comprises, on a second surface opposite to the material, a first positive electrode power supply terminal, a first negative electrode power supply terminal, a first positive electrode area where a positive electrode is exposed, and a first negative electrode area where a negative electrode is exposed.

10. The semiconductor module according to claim 5, wherein:
the material comprises:
a first material that includes a positive electrode power supply area connected to the positive electrode power supply terminal of the semiconductor chip; and
a second material that includes a negative electrode power supply area connected to the negative electrode power supply terminal of the semiconductor chip,
wherein:
the first material and the second material are disposed to sandwich a plurality of the semiconductor chips.

11. The semiconductor module according to claim 5, wherein:
the material comprises a power supply element configured to store or generate electricity and supply power via at least one of the positive electrode power supply area and the negative electrode power supply area.

12. The semiconductor module according to claim 5, wherein:
the semiconductor chip comprises an external communication unit configured to perform wireless communication with an external device outside the semiconductor module via the coil.

13. The semiconductor module according to claim 5, wherein:
the semiconductor chip comprises a power supply element configured to store or generate electricity and supply power via at least one of the positive electrode power supply terminal and the negative electrode power supply terminal.

14. A semiconductor module comprising:
the semiconductor chip according to claim 1; and
a sensor connected to the semiconductor chip by a wire,
wherein the semiconductor chip performs communication with the sensor via the wire.

15. A semiconductor module comprising a first semiconductor chip and a second semiconductor chip according to claim 1, wherein:
the semiconductor module comprises a sensor connected to the first semiconductor chip by a wire,
the processor provided to the first semiconductor chip processes a signal received from the sensor, and transmits processed data to the coil of the second semiconductor chip via the coil of the first semiconductor chip by inductive coupling, and
the processor provided to the second semiconductor chip performs processing based on the data received from the coil of the second semiconductor chip.

16. The semiconductor module according to claim 15, wherein:
a positive electrode power supply terminal of the first semiconductor chip and the positive electrode power supply terminal of the second semiconductor chip are bonded or abutted against the same positive electrode power supply area, and
a negative electrode power supply terminal of the first semiconductor chip and the negative electrode power supply terminal of the second semiconductor chip are bonded or abutted against the same negative electrode power supply area.

17. The semiconductor module according to claim 15, wherein:
a width in a direction in which the first semiconductor chip and the second semiconductor chip are arranged in the positive electrode power supply area and the negative electrode power supply area is at least twice a width of the semiconductor chip.

18. The semiconductor module according to claim 15, comprising:
a third semiconductor chip that includes:
a processor;
a coil for performing wireless communication;
a positive electrode power supply terminal for acquiring a driving power of the processor from outside the semiconductor chip; and
a negative electrode power supply terminal for acquiring the driving power of the processor from outside the semiconductor chip,
wherein:
the positive electrode power supply terminal of the third semiconductor chip is bonded or abutted against the same positive electrode power supply area,
the negative electrode power supply terminal of the third semiconductor chip is bonded or abutted against the same negative electrode power supply area, and
wireless communication is performed by inductive coupling between the coil of the third semiconductor chip and the coil of the second semiconductor chip.

19. A semiconductor chip comprising a processor and a coil, the semiconductor chip comprising:
a communication unit configured to use the coil to perform communication with another semiconductor chip;
a measurement unit configured to use the coil to acquire a measurement value in accordance with a state of the information processing device; and
a power supply unit configured to use the coil to acquire power consumed in the semiconductor chip.

20. The semiconductor chip according to claim 19, wherein: the power supply unit acquires power in a specific frequency band generated in the coil due to an electromagnetic field generated by an external power supply device, and
the communication unit transmits an unmodulated wireless signal to the coil of the other semiconductor chip adjacent to the semiconductor chip via a near-field electromagnetic field.

21. The semiconductor chip according to claim 19, comprising:
a calculation logic storage unit configured to store a calculation logic for calculating a state quantity indicating the state; and
a calculation unit configured to calculate the state quantity from the measurement value by the calculation logic.

22. The semiconductor chip according to claim 19, wherein:
the coil transmits power to a coil outside the semiconductor chip.

23. The semiconductor chip according to claim 19, comprising a positive electrode power supply terminal and a negative electrode power supply terminal configured to acquire a driving power of the processor from outside the semiconductor chip.

24. An information processing device comprising:
the semiconductor chip according to claim 19; and
a power supply device configured to transmit power in a specific frequency band to the coil via an electromagnetic field,
wherein:
the communication unit transmits an unmodulated wireless signal to the coil of the other semiconductor chip adjacent to the semiconductor chip via a near-field electromagnetic field.

25. A semiconductor module comprising:
the semiconductor chip according to claim 19; and a sensor connected to the semiconductor chip by a wire,
wherein:
the semiconductor chip performs communication with the sensor via the wire.

26. A semiconductor module comprising a first semiconductor chip and a second semiconductor chip according to claim 19, wherein:
the semiconductor module comprises a sensor connected to the first semiconductor chip by a wire,
the processor provided to the first semiconductor chip processes a signal received from the sensor, and transmits processed data to the coil of the second semiconductor chip via the coil of the first semiconductor chip by inductive coupling, and
the processor provided to the second semiconductor chip performs processing based on the data received from the coil of the second semiconductor chip.

27. A material that is bonded or abutted against a semiconductor chip including: a processor; a coil for performing wireless communication with another semiconductor chip; a positive electrode power supply terminal; and a negative electrode power supply terminal, the material comprising:
a positive electrode power supply area; and
a negative electrode power supply area,
wherein:
the positive electrode power supply area is bonded or abutted against the positive electrode power supply terminal,
the negative electrode power supply area is bonded or abutted against the negative electrode power supply terminal, and
at least one of an area of the positive electrode power supply area and an area of the negative electrode power supply area is larger than an area of at least one of an end portion of the positive electrode power supply terminal and an end portion of the negative electrode power supply terminal.
